# EUROPEAN PATENT APPLICATION

(11) **EP 4 761 495 A1**
(43) Date of publication of application: **17.06.2026**
(21) Application number: 25217907.2
(22) Date of filing: 24.11.2025
(51) Int. Cl.: H10B 12/00, H10D 30/67, H10D 62/10, G11C 8/14

(54) **SEMICONDUCTOR DEVICE AND METHOD FOR FABRICATING THE SAME**

(30) Priority: 16.12.2024 KR 20240186906
(71) Applicant: SK hynix Inc., Bubal-eub Icheon-si Gyeonggi-do 17336 (KR)
(72) Inventor: SONG, Dong Il, 17336 Icheon-si (KR); KWAK, Jun Ha, 17336 Icheon-si (KR); PARK, Sung Mean, 17336 Icheon-si (KR)
(74) Representative: Isarpatent

(57) **Abstract**

A semiconductor device including high-integrated memory cells and a method for fabricating the semiconductor device is provided. The semiconductor device includes a vertical arrangement and a horizontal arrangement of nano sheets; horizontal conductive lines horizontally oriented while surrounding the horizontal arrangement of the nano sheets; pads coupled to edge portions of the horizontal conductive lines; and inter-pad dielectric layers disposed between the pads, each inter-pad dielectric layer including an air gap.

## Description

### CROSS-REFERENCE TO RELATED APPLICATIONS

The present application claims priority under 35 U.S.C 119(a) to Korean Patent Application No. 10-2024-0186906, filed on December 16, 2024, which is incorporated herein by reference in its entirety.

### BACKGROUND

### 1. Field

Various embodiments of the present disclosure relate generally to a semiconductor device, and more particularly, to a semiconductor device including three-dimensional (3D) memory cells, and a method for fabricating the semiconductor device.

### 2. Description of the Related Art

Recently, in order to cope with the large capacity and miniaturization of a memory device, a three-dimensional (3D) memory device in which a plurality of memory cells are stacked has been proposed.

### SUMMARY

Embodiments of the present disclosure are directed to a semiconductor device including high-integrated memory cells, and a method for fabricating the semiconductor device.

In accordance with an embodiment of the present disclosure, a semiconductor device may include a vertical arrangement and a horizontal arrangement of nano sheets; horizontal conductive lines horizontally oriented while surrounding the horizontal arrangement of the nano sheets; pads coupled to edge portions of the horizontal conductive lines; and inter-pad dielectric layers disposed between the pads, each inter-pad dielectric layer including an air gap.

In accordance with an embodiment of the present disclosure, a method for fabricating a semiconductor device may include forming an alternating stack of pad-side sheets and pad-side sacrificial layers over a substrate; forming growth layers on end terminals of the pad-side sheets and a strip path disposed between the growth layers; removing the pad-side sacrificial layers through the strip path formed between the growth layers to form initial air gaps between the pad-side sheets; forming inter-pad dielectric layers filling the initial air gaps and each including an air gap; forming pad-shaped openings between the inter-pad dielectric layers by removing the pad-side sheets; and forming pads filling the pad-shaped openings.

In accordance with an embodiment of the present disclosure, a semiconductor device may include a substrate; a cell array region including a plurality of horizontal conductive lines vertically stacked in a first direction over the substrate; and a coupling region including pads and inter-pad dielectric layers alternately stacked in the first direction, wherein the inter-pad dielectric layers each include an embedded air gap between the pads.

These and other features and advantages of the embodiments of the present disclosure will become better understood from the following drawings and the detailed description.

### BRIEF DESCRIPTION OF THE DRAWINGS

FIG. 1A is a simplified schematic perspective view illustrating a memory cell in accordance with an embodiment of the present disclosure.
FIG. 1B is a simplified schematic cross-sectional view of the memory cell illustrated in FIG. 1A.
FIG. 2A is a simplified schematic perspective view illustrating a semiconductor device in accordance with an embodiment of the present disclosure.
FIG. 2B is a partial perspective view illustrating a first spacer of the semiconductor device of FIG. 2A.
FIG. 2C is a partial perspective view illustrating a second spacer of the semiconductor device of FIG. 2A.
FIG. 3 is a simplified schematic perspective view illustrating a semiconductor device in accordance with an embodiment of the present disclosure.
FIG. 4A is a simplified schematic perspective view illustrating a semiconductor device in accordance with an embodiment of the present disclosure.
FIG. 4B is a simplified schematic plan view illustrating the semiconductor device illustrated in FIG. 4A.
FIG. 4C is a simplified schematic cross-sectional view of the semiconductor device taken along line A-A' illustrated in FIG. 4B.
FIG. 4D is a simplified schematic cross-sectional view of the semiconductor device taken along line B-B' illustrated in FIG. 4B.
FIGS. 5A to 34B illustrate various views of a semiconductor device formed by utilizing a method for fabricating the semiconductor device in accordance with an embodiment of the present disclosure.
FIG. 35 is a simplified schematic perspective view illustrating a semiconductor device in accordance with an embodiment of the present disclosure.
FIG. 36 is a simplified schematic cross-sectional view of a semiconductor device in accordance with an embodiment of the present disclosure.
FIGS. 37A and 37B are schematic cross-sectional views of a semiconductor device in accordance with embodiments of the present disclosure.
FIGS. 38A and 38B illustrate various views illustrating a stack assembly in accordance with embodiments of the present disclosure.

### DETAILED DESCRIPTION

Various embodiments of the semiconductor device of the present disclosure are described herein with reference to cross-sectional views, plan views and block diagrams, which are ideal schematic views of the semiconductor device. It is noted that the structures of the drawings may be modified by fabricating techniques and/or tolerances and that the embodiments of the present disclosure are not limited to the described embodiments and the specific structures illustrated in the drawings, but may include other embodiments, or modifications of the described embodiments including any changes in the structures that may be produced according to requirements of the fabricating process. Accordingly, the regions illustrated in the drawings have schematic attributes, and the shapes of the regions illustrated in the drawings are intended to illustrate specific structures of regions of the elements, and are not intended to limit the scope of this disclosure.

The following embodiment relates to a 3D semiconductor device including three-dimensional memory cells vertically stacked for increasing memory cell density and reduce parasitic capacitance.

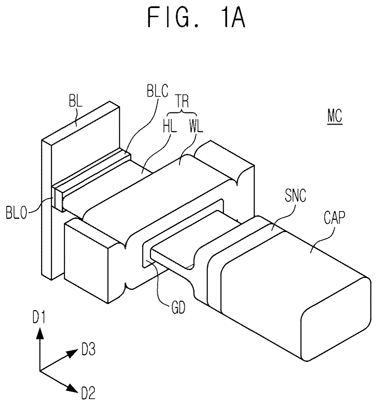

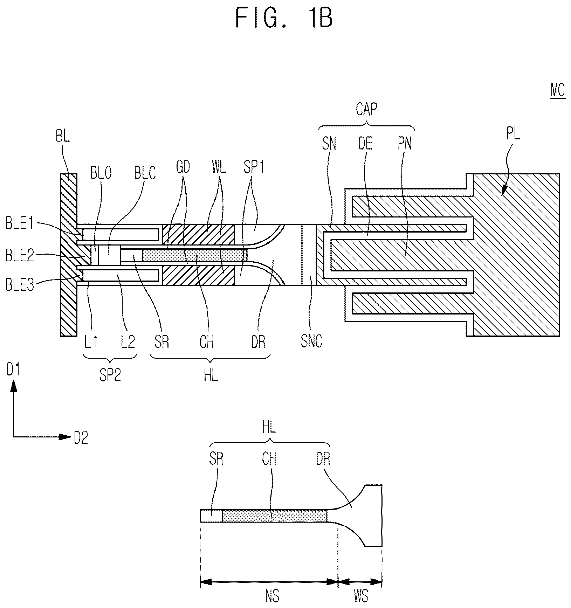

FIG. 1A is a simplified schematic perspective view illustrating a memory cell MC in accordance with an embodiment of the present disclosure. FIG. 1B is a simplified schematic cross-sectional view of the memory cell MC illustrated in FIG. 1A.

Referring to FIGS. 1A and 1B, the memory cell MC may include a first conductive line BL, a switching element TR, and a data storage element CAP operatively coupled to each other with the switching element TR being disposed between the first conductive line BL and the data storage element CAP.

The first conductive line BL may be vertically oriented in a first direction D1. The first conductive line BL may include a bit line. The first conductive line BL may be referred to as a "vertical conductive line", a "vertically-oriented bit line", a "vertical-extending bit line", or a "pillar-shaped bit line". The first conductive line BL may include a conductive material. The first conductive line BL may include a silicon-based material, a metal-based material, or a combination thereof. The first conductive line BL may include polysilicon, metal, metal nitride, metal silicide, or a combination thereof. The first conductive line BL may include polysilicon, titanium nitride, tungsten, or a combination thereof. For example, the first conductive line BL may include a titanium nitride/tungsten (TiN/W) stack in which titanium nitride and tungsten are sequentially stacked.

The switching element TR has a function of controlling voltage or current supply to the data storage element CAP during a data write operation and/or a data read operation performed on the data storage element CAP. The switching element TR may include a nano sheet HL, a nano sheet dielectric layer GD, and a second conductive line WL. The second conductive line WL may include a horizontal conductive line or a horizontal word line, and the nano sheet HL may include an active layer. The switching element TR may include a transistor. In an embodiment, the switching element TR may be a transistor, and in this case, the second conductive line WL may serve as a gate electrode. The switching element TR may also be referred to as a "nano sheet transistor," a "cell transistor," an "access element," or a "selection element". The second conductive line WL may be referred to as a "horizontal gate electrode," or a "horizontal word line".

The nano sheet HL may extend in a second direction D2 that intersects with the first direction D1. The second conductive line WL may extend in a third direction D3 that intersects with the first direction D1 and the second direction D2. The first direction D1 may be a vertical direction, the second direction D2 may be a first horizontal direction, and the third direction D3 may be a second horizontal direction. The nano sheet HL may extend in the first horizontal direction, i.e., the second direction D2, and the second conductive line WL may extend in the second horizontal direction, i.e., the third direction D3. The nano sheet HL may also be referred to as a "horizontal layer," or a "horizontal nanosheet layer".

The nano sheet HL may include a channel CH, a first doped region SR disposed between the channel CH and the first conductive line BL, and a second doped region DR disposed between the channel CH and the data storage element CAP. The first doped region SR may be coupled to the first conductive line BL, and the second doped region DR may be coupled to the data storage element CAP. A height of the second doped region DR in the first direction D1 may be greater than a height of the channel CH in the first direction D1. A length of the second doped region DR in the second direction D2 may be less than a length of the channel CH in the second direction D2. The lengths of the first doped region SR, the channel CH and the second doped region DR in the third direction D3 may be equal to one another.

The nano sheet HL may include a first nano sheet region NS and a second nano sheet region WS that are horizontally disposed in the second direction D2. The second nano sheet region WS may extend from an end of the first nano sheet region NS. The second nano sheet region WS may have a thickness that gradually increases in the second direction D2 from the first nano sheet region NS toward the data storage element CAP between the first nano sheet region NS and the data storage element CAP. An average vertical height or thickness of the second nano sheet region WS in the first direction D1 may be greater than an average vertical height or thickness of the first nano sheet region NS. Hereinafter, the first nano sheet region NS may also be referred to as a "narrow nano sheet", and the second nano sheet region WS is referred to as a "wide nano sheet".

The narrow nano sheet NS may have a flat plate shape. The wide nano sheet WS may have a fan-like shape. The wide nano sheet WS may have a thickness that gradually increases in the second direction D2. The narrow nano sheet NS may be referred to as a "flat plate-shaped sheet", and the wide nano sheet WS may be referred to as a "fan-like shaped sheet". A boundary portion between the narrow nano sheet NS and the wide nano sheet WS may have a curvature.

The first doped region SR and the channel CH may be disposed in the narrow nano sheet NS, and the second doped region DR may be disposed in the wide nano sheet WS. The channel CH formed in the narrow nano sheet NS may be referred to as a "narrow channel" or a "flat channel". A portion of the second doped region DR may extend to be disposed in the narrow nano sheet NS. The second doped region DR may include a thick portion disposed in the wide nano sheet WS and a thin portion disposed in the narrow nano sheet NS. One side of the wide nano sheet WS and one side of the second doped region DR, which contact the data storage element CAP, may each have a flat side shape.

A horizontal length of the wide nano sheet WS in the second direction D2 may be less than a horizontal length of the narrow nano sheet NS. The narrow nano sheet NS may be referred to as a "long nano sheet", and the wide nano sheet WS may be referred to as a "short nano sheet".

The nano sheet HL may include a semiconductive material. For example, the nano sheet HL may include polysilicon, monocrystalline silicon, germanium, or silicon-germanium. In some embodiments, the nano sheet HL may include an oxide semiconductor material. For example, the oxide semiconductor material may include indium gallium zinc oxide (IGZO), InSnZnO, ZnSnO, or a combination thereof. In some embodiments, the nano sheet HL may include conductive metal oxide. In some embodiments, the nano sheet HL may include a two-dimensional material, for example, MoS₂, WS₂, or MoSe₂.

When the nano sheet HL is formed of the oxide semiconductor material, the channel CH may also be formed of the oxide semiconductor material, and the first and second doped regions SR and DR may be omitted. The nano sheet HL may also be referred to as an "active layer" or a "thin body".

The first doped region SR and the second doped region DR may be doped with the same conductivity type of an impurity. Each of the first doped region SR and the second doped region DR may be doped with an N-type conductive impurity or a P-type conductive impurity. The first doped region SR and the second doped region DR may each include at least one impurity selected from among arsenic (As), phosphorus (P), boron (B), indium (In), and combinations thereof. The first doped region SR may be coupled to the first conductive line BL, and the second doped region DR may be coupled to the data storage element CAP. The first and second doped regions SR and DR may be referred to as "first and second source/drain regions".

The nano sheet HL may be horizontally oriented in the second direction D2 from the first conductive line BL.

The second conductive line WL may have a gate-all-around (GAA) structure. For example, the second conductive line WL may surround the nano sheet HL and extend in the third direction D3. The nano sheet dielectric layer GD may be formed between the nano sheet HL and the second conductive line WL. The nano sheet dielectric layer GD may surround the nano sheet HL. The second conductive line WL may surround the nano sheet HL on the nano sheet dielectric layer GD.

The second conductive line WL may include a metal-based material, a semiconductive material, or a combination thereof. The second conductive line WL may include molybdenum, molybdenum nitride, ruthenium, titanium nitride, tungsten, polysilicon, or a combination thereof. For example, the second conductive line WL may include a TiN/W stack in which titanium nitride and tungsten are sequentially stacked. The second conductive line WL may include an N-type work function material or a P-type work function material. The N-type work function material may have a low work function of approximately 4.5 eV or less, and the P-type work function material may have a high work function of approximately 4.5 eV or greater. The second conductive line WL may include a stack of a low work function material and a high work function material.

The nano sheet dielectric layer GD may be disposed between the nano sheet HL and the second conductive line WL. The nano sheet dielectric layer GD may be referred to as a "gate dielectric layer" or a "channel-side dielectric layer". The nano sheet dielectric layer GD may include, for example, silicon oxide, silicon nitride, metal oxide, metal oxide nitride, metal silicate, a high-k material, a ferroelectric material, an anti-ferroelectric material, or a combination thereof. The nano sheet dielectric layer GD may include SiO₂, Si₃N₄, HfO₂, Al₂O₃, ZrO₂, AlON, HfON, HfSiO, HfSiON, HfZrO, or a combination thereof. The nano sheet dielectric layer GD may be formed by a thermal oxidation process of a semiconductive material.

The data storage element CAP may include a memory element such as a capacitor. The data storage element CAP may be horizontally disposed in the second direction D2 from the switching element TR. The data storage element CAP may include a first electrode SN, a second electrode PN on the first electrode SN, and a dielectric layer DE between the first electrode SN and the second electrode PN. The first electrode SN may horizontally extend in the second direction D2 from the nano sheet HL. The first electrode SN, the dielectric layer DE and the second electrode PN may be horizontally disposed in the second direction D2. The first electrode SN may include an inner space and a plurality of outer surfaces, and the inner space of the first electrode SN may include a plurality of inner surfaces. The outer surfaces of the first electrode SN may include a vertical outer surface and a plurality of horizontal outer surfaces. The vertical outer surface of the first electrode SN may vertically extend in the first direction D1, and the horizontal outer surfaces of the first electrode SN may horizontally extend in the second direction D2 or the third direction D3. The inner space of the first electrode SN may be a three-dimensional space. The dielectric layer DE may conformally cover the inner surfaces of the first electrode SN. The second electrode PN may be disposed in the inner space of the first electrode SN on the dielectric layer DE. Some of the outer surfaces of the first electrode SN may be electrically coupled to the second doped region DR of the nano sheet HL. The second electrode PN of the data storage element CAP may be coupled to a common plate PL.

The data storage element CAP may have a three-dimensional structure. The first electrode SN may have a three-dimensional structure, which may have a horizontal three-dimensional structure that is oriented in the second direction D2. In an example of the three-dimensional structure, the first electrode SN may have a cylindrical shape. The cylindrical shape of the first electrode SN may include cylindrical inner surfaces and cylindrical outer surfaces. Some of the cylindrical outer surfaces of the first electrode SN may be electrically coupled to the second doped region DR of the nano sheet HL. The dielectric layer DE and the second electrode PN may be disposed on the cylindrical inner surfaces of the first electrode SN.

In some embodiments, the first electrode SN may have a pillar shape or a pylinder shape. The pylinder shape may refer to a structure in which a pillar shape and a cylindrical shape are merged.

The first electrode SN and the second electrode PN may include metal, noble metal, metal nitride, conductive metal oxide, conductive noble metal oxide, metal carbide, metal silicide, or a combination thereof. For example, the first electrode SN and the second electrode PN may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum nitride (MoN), molybdenum oxide (MoO), a titanium nitride/tungsten (TiN/W) stack, a tungsten nitride/tungsten (WN/W) stack, a titanium silicon nitride/titanium nitride (TiSiN/TiN) stack, a titanium nitride/titanium silicon nitride (TiN/TiSiN) stack, or a combination thereof. The second electrode PN may also include a combination of a metal-based material and a silicon-based material. For example, the second electrode PN may be a titanium nitride/silicon germanium/tungsten nitride (TiN/SiGe/WN) stack. In the titanium nitride/silicon germanium/tungsten nitride (TiN/SiGe/WN) stack, silicon germanium may be a gap-fill material that fills the inside of the first electrode SN, titanium nitride (TiN) may serve as the second electrode PN of the data storage element CAP, and tungsten nitride may be a low-resistance material.

The dielectric layer DE may be referred to as a "capacitor dielectric layer" or a "memory layer". The dielectric layer DE may include, for example, silicon oxide, silicon nitride, a high-k material, a perovskite material, or a combination thereof. The high-k material may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅), or strontium titanium oxide (SrTiO₃). In some embodiments, the dielectric layer DE may be formed of a composite layer including two or more layers of the above-described high-k material.

The dielectric layer DE may be formed of zirconium (Zr)-based oxide. The dielectric layer DE may have a stack structure containing zirconium oxide (ZrO₂). The dielectric layer DE may include a ZA (ZrO₂/Al₂O₃) stack or a ZAZ (ZrO₂/Al₂O₃/ZrO₂) stack. The ZA stack may have a structure in which aluminum oxide (Al₂O₃) is stacked on zirconium oxide (ZrO₂). The ZAZ stack may have a structure in which zirconium oxide (ZrO₂), aluminum oxide (Al₂O₃) and zirconium oxide (ZrO₂) are sequentially stacked. Each of the ZA stack and the ZAZ stack may be referred to as a "zirconium oxide (ZrO₂)-based layer". In some embodiments, the dielectric layer DE may be formed of hafnium (Hf)-based oxide. The dielectric layer DE may have a stack structure containing hafnium oxide (HfO₂). The dielectric layer DE may include an HA (HfO₂/Al₂O₃) stack or an HAH (HfO₂/Al₂O₃/HfO₂) stack. The HA stack may have a structure in which aluminum oxide (Al₂O₃) is stacked on hafnium oxide (HfO₂). The HAH stack may have a structure in which hafnium oxide (HfO₂), aluminum oxide (Al₂O₃) and hafnium oxide (HfO₂) are sequentially stacked. Each of the HA stack and the HAH stack may be referred to as a "hafnium oxide (HfO₂)-based layer". In the ZA stack, ZAZ stack, HA stack and HAH stack, aluminum oxide (Al₂O₃) may have a greater band gap energy than zirconium oxide (ZrO₂) and hafnium oxide (HfO₂). Aluminum oxide (Al₂O₃) may have a lower dielectric constant than zirconium oxide (ZrO₂) and hafnium oxide (HfO₂). Accordingly, the dielectric layer DE may include a stack of a high-k material and a high band gap material having a greater band gap energy than the high-k material. The dielectric layer DE may include, for example, silicon oxide (SiO₂) as a high band gap material other than aluminum oxide (Al₂O₃). Because the dielectric layer DE includes a high band gap material, leakage current may be suppressed. The high band gap material may be thinner than the high-k material. In some embodiments, the dielectric layer DE may include a stack structure in which a high-k material and a high band gap material are alternately stacked. For example, the dielectric layer DE may include a ZAZA (ZrO₂/Al₂O₃/ZrO₂/Al₂O₃) stack, a ZAZAZ (ZrO₂/Al₂O₃/ZrO₂/Al₂O₃/ZrO₂) stack, a HAHA (HfO₂/Al₂O₃/HfO₂/Al₂O₃) stack, a HAHAH (HfO₂/Al₂O₃/HfO₂/Al₂O₃/HfO₂) stack, a HZAZH (HfO₂/ZrO₂/Al₂O₃/ZrO₂/HfO₂) stack, a ZHZAZHZ (ZrO₂/HfO₂/ZrO₂/Al₂O₃/ZrO₂/HfO₂/ZrO₂) stack, a HZHZ (HfO₂/ZrO₂/HfO₂/ZrO₂) stack, or an AHZAZHA (Al₂O₃/HfO₂/ZrO₂/Al₂O₃/ZrO₂/HfO₂/Al₂O₃) stack. In the above-described stack structures, aluminum oxide (Al₂O₃) may be thinner than zirconium oxide (ZrO₂) and hafnium oxide (HfO₂).

In some embodiments, the dielectric layer DE may include a high-k material and a high band gap material. The dielectric layer DE may have a laminated structure in which a plurality of high-k materials and a plurality of high band gap materials are stacked or an intermixed structure in which a high-k material and a high band gap material are intermixed.

In some embodiments, the dielectric layer DE may include a ferroelectric material, an anti-ferroelectric material, or a combination thereof. For example, the dielectric layer DE may include HfZrO.

In some embodiments, the dielectric layer DE may include a combination of a high-k material and a ferroelectric material, a combination of a high-k material and an anti-ferroelectric material, or a combination of a high-k material or a ferroelectric material and an anti-ferroelectric material.

In some embodiments, an interface control layer may be further formed between the first electrode SN and the dielectric layer DE to alleviate leakage current. The interface control layer may include titanium oxide (TiO₂), tantalum oxide (Ta₂O₅), niobium oxide (Nb₂O₅), niobium nitride (NbN), or a combination thereof. The interface control layer may also be formed between the second electrode PN and the dielectric layer DE.

The data storage element CAP may include a three-dimensional capacitor. The data storage element CAP may include a Metal-Insulator-Metal (MIM) capacitor. The data storage element CAP may be replaced with another data storage material. For example, the data storage material may be a thyristor, a phase-change material, a Magnetic Tunnel Junction (MTJ), or a variable resistance material.

The memory cell MC may further include a first contact node BLC and a second contact node SNC. The first contact node BLC may be disposed between the first conductive line BL and the nano sheet HL. The first contact node BLC may include a metal-based material or a semiconductive material. For example, the first contact node BLC may include titanium, titanium nitride, tungsten, or a combination thereof. In addition, the first contact node BLC may include doped silicon, and the first doped region SR may include an impurity diffused from the first contact node BLC. The second contact node SNC may be disposed between the nano sheet HL and the first electrode SN. The second contact node SNC may include a metal-based material or a semiconductive material. For example, the second contact node SNC may include titanium, titanium nitride, tungsten, or a combination thereof. In addition, the second contact node SNC may include doped silicon, and the second doped region DR may include an impurity diffused from the second contact node SNC. A height of the first contact node BLC in the first direction D1 may be less than a height of the second contact node SNC in the first direction D1. The height of the first contact node BLC in the first direction D1 may be greater than a height of the channel CH in the first direction D1. The first and second contact nodes BLC and SNC may each include phosphorus-doped polysilicon or arsenic-doped polysilicon.

The nano sheet HL may include a first edge and a second edge. The first edge may refer to a portion of the first doped region SR electrically coupled to the first conductive line BL, and the second edge may refer to a portion of the second doped region DR electrically coupled to the first electrode SN of the data storage element CAP.

The memory cell MC may further include an ohmic contact layer BLO between the first contact node BLC and the first conductive line BL. The ohmic contact layer BLO may include metal silicide such as titanium silicide or molybdenum silicide.

The memory cell MC may further include a first spacer SP1 and a second spacer SP2. The first spacer SP1 may be disposed between the second conductive line WL and the second doped region DR. The second spacer SP2 may be disposed between the first conductive line BL and the second conductive line WL. The second spacer SP2 may include a stack of a first liner L1 and a second liner L2. The first and second spacers SP1 and SP2 may each include a dielectric material. The first and second spacers SP1 and SP2 may each include, for example, silicon oxide, silicon nitride, or a combination thereof. The first spacer SP1 may include silicon nitride. The first liner L1 of the second spacer SP2 may be silicon nitride, whereas the second liner L2 of the second spacer SP2 may be silicon oxide. The second liner L2 may partially fill an inner space of the first liner L1.

The first conductive line BL may include a plurality of horizontal extension portions BLE1, BLE2, and BLE3. The horizontal extension portions BLE1, BLE2, and BLE3 may extend in the second direction D2. The horizontal extension portions may include an inner horizontal extension portion BLE2 and outer horizontal extension portions BLE1 and BLE3. The inner horizontal extension portion BLE2 of the first conductive line BL may extend to be disposed in a gap between the first liners L1 vertically adjacent to each other. Accordingly, the inner horizontal extension portion BLE2 of the first conductive line BL may be electrically coupled to the ohmic contact layer BLO.

The outer horizontal extension portions BLE1 and BLE3 of the first conductive line BL may extend to be disposed in one side of the second spacer SP2. Accordingly, the outer horizontal extension portions BLE1 and BLE3 of the first conductive line BL may contact the second liner L2 of the second spacer SP2.

In an embodiment, the second contact node SNC may be selectively grown from the wide nano sheet WS of the nano sheet HL. The second contact node SNC may be formed by selective epitaxial growth (SEG). For example, the second contact node SNC may be a silicon epitaxial layer formed by the SEG. The second contact node SNC may be a doped silicon epitaxial layer.

In some embodiments, the first contact node BLC may also be selectively grown from the narrow nano sheet NS of the nano sheet HL. The first contact node BLC may be formed by selective epitaxial growth (SEG). For example, the first contact node BLC may be a silicon epitaxial layer formed by the SEG. The first contact node BLC may be a doped silicon epitaxial layer.

The first contact node BLC may be a narrow nano sheet-side contact node, and the second contact node SNC may be a wide nano sheet-side contact node.

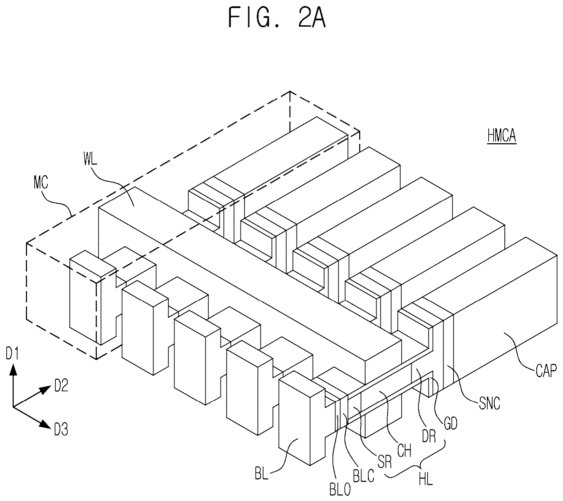

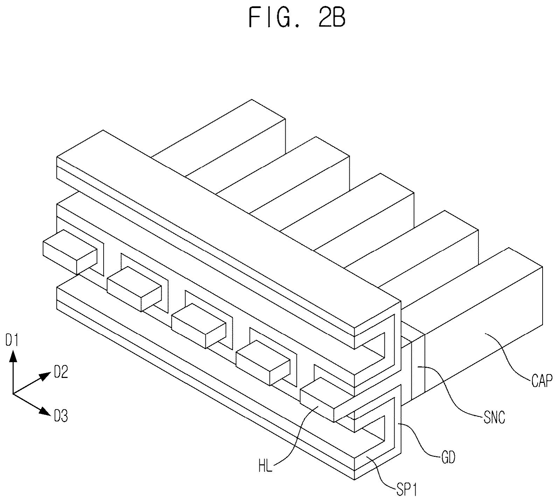

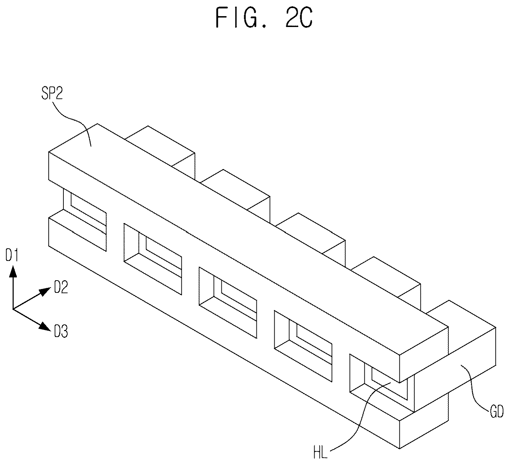

FIG. 2A is a simplified schematic view illustrating a semiconductor device in accordance with an embodiment of the present disclosure. FIG. 2B is a partial perspective view illustrating a first spacer SP1 employed in the semiconductor device of FIG. 2A. FIG. 2C is a partial perspective view illustrating a second spacer SP2 employed in the semiconductor device of FIG. 2A.

FIG. 2A illustrates a horizontal array HMCA including a plurality of memory cells MC as the one described above with reference to FIG. 1A.

Referring to FIGS. 2A to 2C, the horizontal array HMCA may include a horizontal arrangement of the memory cells MC. The memory cells MC of the horizontal array HMCA may be horizontally spaced apart from each other in a third direction D3. Each of the memory cells MC of the horizontal array HMCA may be coupled to a different one of first conductive lines BL. The memory cells MC of the horizontal array HMCA may share one second conductive line WL which extends in the third direction D3. Each of the memory cells MC may include a first conductive line BL, a nano sheet HL, and a data storage element CAP. The nano sheet HL may include a first doped region SR, a channel CH, and a second doped region DR. A first contact node BLC and an ohmic contact layer BLO may be formed between the first doped region SR of the nano sheet HL and the first conductive line BL. A second contact node SNC may be formed between the second doped region DR of the nano sheet HL and the data storage element CAP. The nano sheet HL may be surrounded by a nano sheet dielectric layer GD. The second conductive line WL may extend in the third direction D3 while surrounding the channels CH of the nano sheets HL on the nano sheet dielectric layer GD. As described with reference to FIG. 1B, the nano sheet HL may include a narrow nano sheet NS and a wide nano sheet WS, and a boundary portion between the narrow nano sheet NS and the wide nano sheet WS may have a curvature.

Each of the memory cells MC may further include a first spacer SP1 and a second spacer SP2.

Referring back to FIG. 2B, the first spacer SP1 may include protruding portions surrounding portions of the nano sheets HL, i.e., the second doped regions DR. The protruding portions of the first spacer SP1 may be merged with each other and extend in the third direction D3. The first spacer SP1 may have an integral structure extending in a first direction D1. The protruding portions of the first spacer SP1 may have a cup shape, and a cross-section of the protruding portions may have a ⊃ shape.

Referring back to FIG. 2C, the second spacer SP2 may extend in the third direction D3 while surrounding portions of the nano sheets HL, i.e., the first doped regions SR.

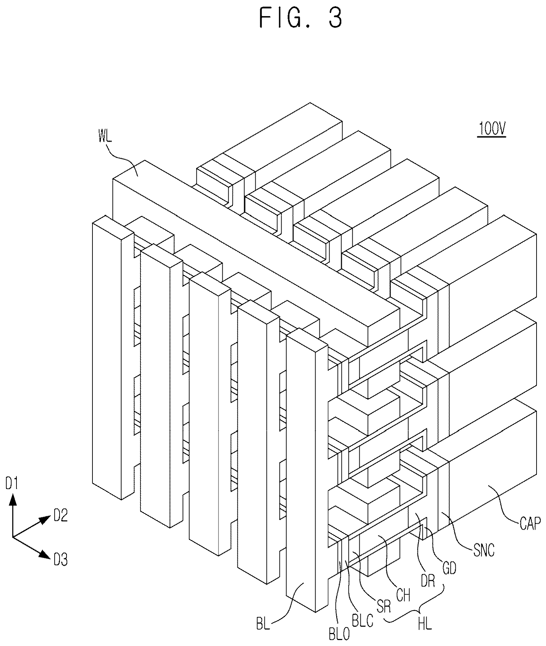

FIG. 3 is a simplified schematic perspective view illustrating a semiconductor device 100V in accordance with an embodiment of the present disclosure. The semiconductor device 100V illustrated in FIG. 3 may include a structure in which a plurality of horizontal arrays like the one illustrated in FIG. 2A are vertically stacked in a first direction D1. Detailed descriptions of overlapping components are provided above with reference to FIGS. 1A to 2C.

Referring to FIG. 3, the semiconductor device 100V may include a vertical stack of horizontal arrays HMCA. The semiconductor device 100V may include a horizontal arrangement of a plurality of first conductive lines BL and a vertical arrangement of a plurality of second conductive lines WL. Each vertical arrangement of memory cells MC stacked in the first direction D1 may share a corresponding one of the first conductive lines BL. Also, each of the memory cells making a horizontal arrangement of memory cells MC arranged in a third direction D3 may be coupled to a different one of first conductive lines BL.

The horizontal arrangement of memory cells MC arranged in the third direction D3 may share a corresponding one of the second conductive lines WL. Each of the memory cells in each vertical arrangement of memory cells MC stacked in the first direction D1 may be coupled to different second conductive lines WL. The second conductive lines WL may each have a gate-all-around (GAA) structure.

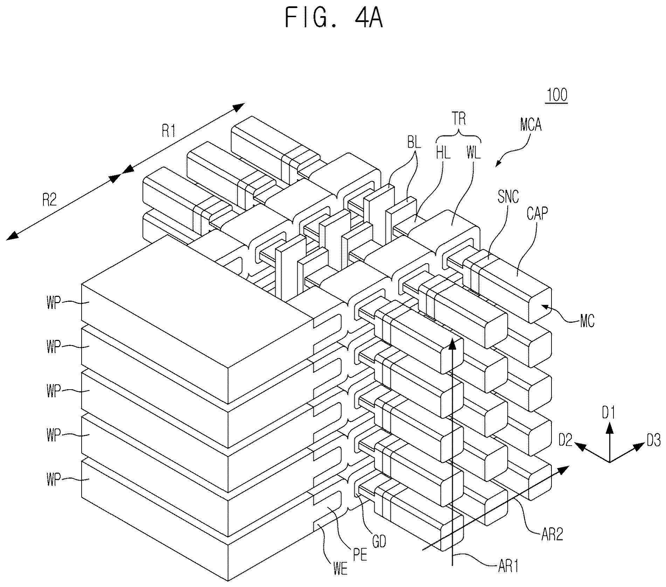

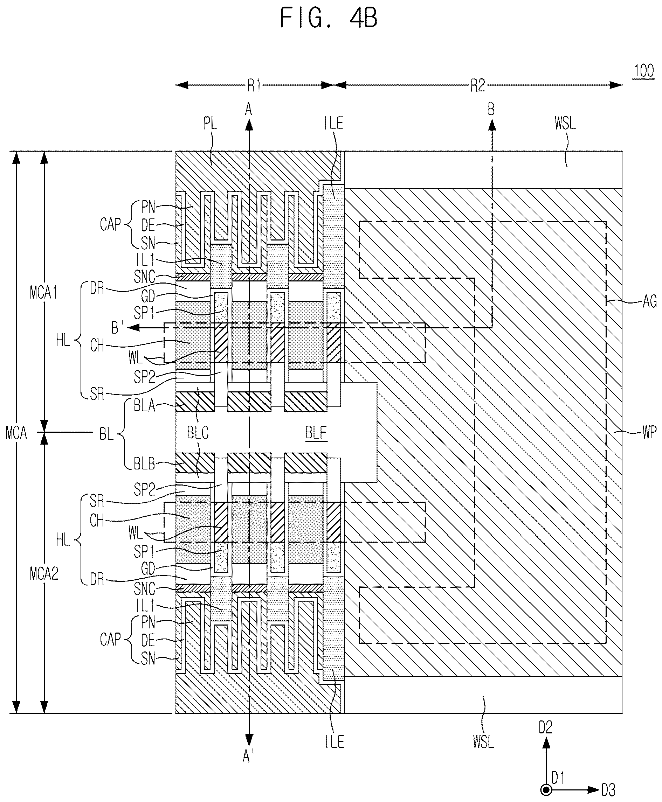

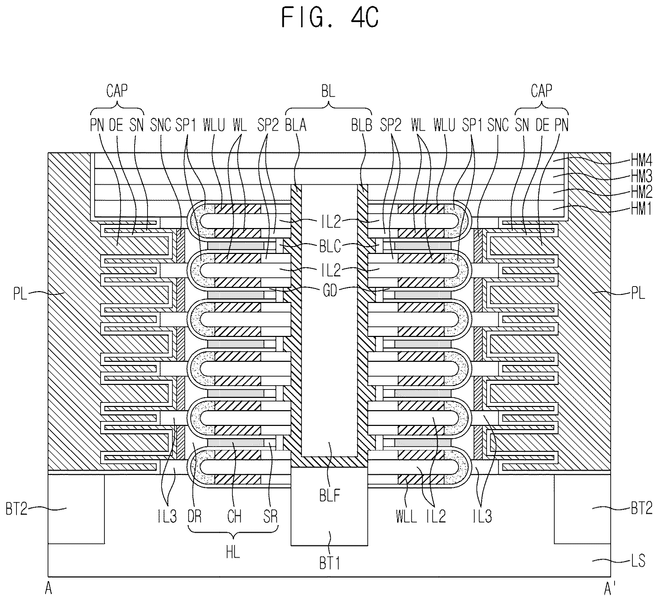

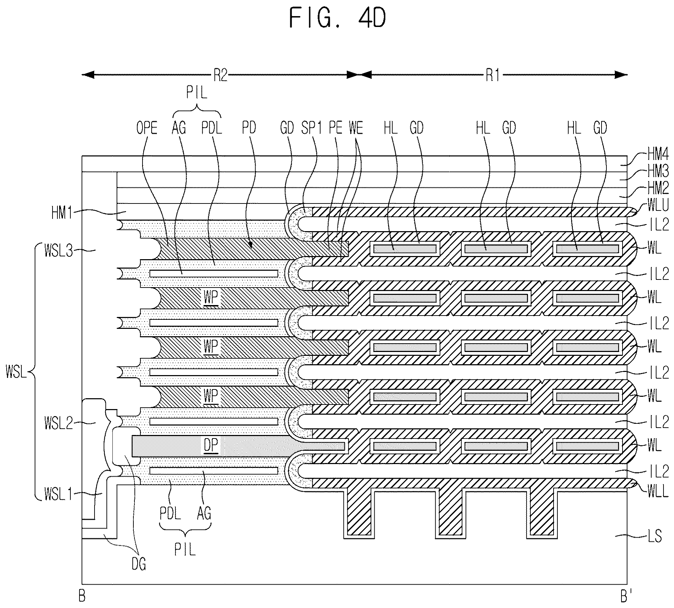

FIG. 4A is a simplified schematic perspective view illustrating a semiconductor device 100 in accordance with an embodiment of the present disclosure. FIG. 4B is a simplified schematic plan view illustrating the semiconductor device 100 illustrated in FIG. 4A. FIG. 4C is a simplified schematic cross-sectional view of the semiconductor device 100 taken along line A-A' illustrated in FIG. 4B. FIG. 4D is a simplified schematic cross-sectional view of the semiconductor device 100 taken along line B-B' illustrated in FIG. 4B. Detailed descriptions of overlapping components are provided above with reference to FIGS. 1A to 3.

Referring to FIGS. 4A to 4D, the semiconductor device 100 may include a memory cell array MCA. The memory cell array MCA may include a three-dimensional array of memory cells MC. The memory cell array MCA may include a first region R1 and a second region R2. The first region R1 may be a region in which the three-dimensional array of memory cells MC is formed, and the second region R2 may be a region in which pads WP coupled to second conductive lines WL of the memory cells MC are formed. The first region R1 may be referred to as an "array region", and the second region R2 may be referred to as a "pad" region or a "coupling region". The first region R1 may include a vertical stack of the memory cells MC, and the second region R2 may include a vertical stack of the pads WP.

Each of the memory cells MC may include a first conductive line BL, a switching element TR, and a data storage element CAP. The switching element TR may include a second conductive line WL, a nano sheet dielectric layer GD, and a nano sheet HL.

The memory cell array MCA may include a column array AR1 of the memory cells MC and a row array AR2 of the memory cells MC. The column array AR1 may include a plurality of memory cells MC vertically stacked in a first direction D1. The memory cells MC of the column array AR1 may share the first conductive line BL. The row array AR2 may include a plurality of memory cells MC horizontally disposed in a third direction D3. The memory cells MC of the row array AR2 may share the second conductive line WL. The first direction D1 may be a vertical direction, and the third direction D3 may be a horizontal direction.

The memory cell array MCA may include a first sub-cell array MCA1 and a second sub-cell array MCA2. The first sub-cell array MCA1 and the second sub-cell array MCA2 may each include a three-dimensional array of the memory cells MC. The first sub-cell array MCA1 and the second sub-cell array MCA2 may share the first conductive line BL. The first conductive line BL may include a first vertical conductive line BLA and a second vertical conductive line BLB. A bottom portion of the first vertical conductive line BLA and a bottom portion of the second vertical conductive line BLB may be merged with each other. The first conductive line BL may have a U shape formed by merging the first vertical conductive line BLA and the second vertical conductive line BLB. The memory cells MC of the first sub-cell array MCA1 may share the first vertical conductive line BLA, and the memory cells MC of the second sub-cell array MCA2 may share the second vertical conductive line BLB. In this way, the neighboring first and second sub-cell arrays MCA1 and MCA2 may have a mirror-type structure of sharing the first conductive line BL. From the perspective of a top view, the first and second vertical conductive lines BLA and BLB may each have a rectangular shape.

Each of the memory cells MC of the first sub-cell array MCA1 may include the first vertical conductive line BLA, the switching element TR, and the data storage element CAP. The switching element TR may include the second conductive line WL and the nano sheet HL. Each of the memory cells MC of the second sub-cell array MCA2 may include the second vertical conductive line BLB, the switching element TR, and the data storage element CAP. The switching element TR may include the second conductive line WL and the nano sheet HL. The switching elements TR of the memory cells MC may be nano sheet transistors.

The first conductive line BL may vertically extend in the first direction D1. The nano sheet HL may extend in a second direction D2. The second conductive line WL may horizontally extend in the third direction D3.

A first inter-cell dielectric layer IL1 may be disposed between the data storage elements CAP disposed adjacent to each other in the third direction D3. A second inter-cell dielectric layer IL2 may be disposed between the second conductive lines WL vertically stacked in the first direction D1. A third inter-cell dielectric layer IL3 may be disposed between first electrodes SN of the data storage elements CAP vertically stacked in the first direction D1. The first to third inter-cell dielectric layers IL1, IL2 and IL3 may each include, for example, silicon oxide, silicon carbon oxide (SiCO), silicon nitride, or a combination thereof. The first inter-cell dielectric layer IL1 may be referred to as a "device isolation layer". Edge first inter-cell dielectric layers ILE may be disposed at a boundary portion between the first region R1 and the second region R2.

Each of the memory cells MC may further include a first contact node BLC and a second contact node SNC. The first contact node BLC may be disposed between the first conductive line BL and the nano sheet HL. The first contact node BLC may include a metal-based material or a semiconductive material. For example, the first contact node BLC may include titanium, titanium nitride, tungsten, or a combination thereof. In addition, the first contact node BLC may include doped polysilicon, and a first doped region SR may include an impurity diffused from the first contact node BLC. The second contact node SNC may be disposed between the nano sheet HL and the first electrode SN. The second contact node SNC may include a metal-based material or a semiconductive material. For example, the second contact node SNC may include titanium, titanium nitride, tungsten, or a combination thereof. In addition, the second contact node SNC may include doped polysilicon, and a second doped region DR may include an impurity diffused from the second contact node SNC. A height of the first contact node BLC in the first direction D1 may be less than a height of the second contact node SNC in the first direction D1. The height of the first contact node BLC in the first direction D1 may be greater than a height of a channel CH in the first direction D1. The first and second contact nodes BLC and SNC may each include phosphorus-doped polysilicon or arsenic-doped polysilicon.

The memory cell MC may further include an ohmic contact layer (refer to reference symbol "BLO" of FIG. 3) between the first contact node BLC and the first conductive line BL. The ohmic contact layer may include metal silicide, such as titanium silicide or molybdenum silicide.

The memory cell MC may further include a first spacer SP1 and a second spacer SP2. The first spacer SP1 may be disposed between the second conductive line WL and the second doped region DR. The second spacer SP2 may be disposed between the first conductive line BL and the second conductive line WL. The first and second spacers SP1 and SP2 may each include a dielectric material. The first and second spacers SP1 and SP2 may each include, for example, silicon oxide, silicon nitride, or a combination thereof. The second spacer SP2 may include a combination of a first liner L1 and a second liner L2, as described above with reference to FIG. 1B.

The memory cell array MCA may include a plurality of second conductive lines WL vertically stacked in the first direction D1. The memory cell array MCA may include a plurality of nano sheets HL vertically stacked in the first direction D1. The memory cell array MCA may include a plurality of data storage elements CAP vertically stacked in the first direction D1. The memory cell array MCA may include a plurality of first conductive lines BL spaced apart in the third direction D3. The memory cell array MCA may include dummy second conductive lines WLU disposed at a level higher than an uppermost second conductive line WL, and dummy second conductive lines WLL disposed at a level lower than a lowermost second conductive line WL. The dummy second conductive lines WLU and WLL may each have a linear shape extending horizontally.

The memory cell array MCA may include a stack of a plurality of hard mask layers HM1, HM2, HM3 and HM4 disposed at a level higher than the uppermost second conductive line WL.

The memory cell array MCA may include a plurality of first and second bottom passivation layers BT1 and BT2. The first bottom passivation layer BT1 may prevent a bottom surface of the first conductive line BL and a lower structure LS from coming into electrical contact with each other. The second bottom passivation layer BT2 may prevent the data storage element CAP and the lower structure LS from coming into electrical contact with each other.

A vertical isolation layer BLF may be disposed between the first vertical conductive line BLA and the second vertical conductive line BLB of the first conductive line BL. The vertical isolation layer BLF may include a dielectric material.

The nano sheets HL of the switching elements TR horizontally disposed in the third direction D3 may share one second conductive line WL. The nano sheets HL of the switching elements TR horizontally disposed in the third direction D3 may be coupled to different first conductive lines BL. The switching elements TR stacked in the first direction D1 may share one first conductive line BL. The switching elements TR horizontally disposed in the third direction D3 may share one second conductive line WL.

Second electrodes PN of the data storage elements CAP may be coupled to a common plate PL.

Referring to FIGS. 4A, 4B and 4D, each of the second conductive lines WL of the memory cell array MCA may be coupled to a different one of the pads WP. The second conductive lines WL may each include an edge portion WE having a concave shape. Each of the pads WP may include an inner edge PE and an outer edge OPE as illustrated FIG. 4D. The inner edge PE of the pad WP may have a convex shape, and the outer edge OPE of the pad WP may have a concave shape.

The inner edge PE of each of the pads WP may be disposed in an inner space of the edge portion WE of a corresponding one of the second conductive lines WL. The inner edge PE of the pad WP and the edge portion WE of the second conductive line WL may be electrically coupled to each other. The inner edge PE of the pad WP and the edge portion WE of the second conductive line WL may contact the first spacer SP1.

An inter-pad isolation layer PIL (See FIG. 4D) may be disposed between the pads WP vertically stacked in the first direction D1. The inter-pad isolation layer PIL may include an inter-pad dielectric layer PDL and an air gap AG. The air gap AG may be embedded in the inter-pad dielectric layer PDL. For example, the air gap AG may, for example, be embedded centrally within the inter-pad dielectric layer PDL. The inter-pad dielectric layer PDL may include a dielectric material. The inter-pad dielectric layer PDL may include, for example, silicon oxide, silicon nitride, silicon carbon oxide, or a combination thereof. An end terminal of the inter-pad dielectric layer PDL and the outer edge OPE of the pad WP may not be self-aligned.

The outer edges OPE of the pads WP may contact a pad support layer WSL. The pad support layer WSL may include a stack of a first pad support layer WSL1, a second pad support layer WSL2 and a third pad support layer WSL3. The stack of the first and second pad support layers WSL1, and WSL2 may be a lower pad support layer. A dummy growth layer DG and a dummy sheet DP may be disposed between the first pad support layer WSL1 and the inter-pad isolation layer PIL. The pad support layer WSL may be disposed between the pads WP that are disposed adjacent to each other in the second direction D2.

A horizontal length of the air gap AG in the third direction D3 may be less than a horizontal length of the pad WP.

As described above, the semiconductor device 100 may include the vertical and horizontal arrangements of the nano sheets HL, the second conductive lines WL horizontally oriented while surrounding the horizontal arrangement of the nano sheets HL, the pads WP each coupled to a different one of the edge portions of the second conductive lines WL, and the inter-pad isolation layers PIL each including an air gap AG and inter-pad dielectric layer PDL disposed between the pads WP.

Forming the air gap AG between the pads WP reduces the parasitic capacitance between the pads WP which may occur in the second region R2. Thus, parasitic capacitance between the second conductive lines WL may be reduced by the air gaps AG. Accordingly, an RC delay may be minimized during operation of the second conductive lines WL.

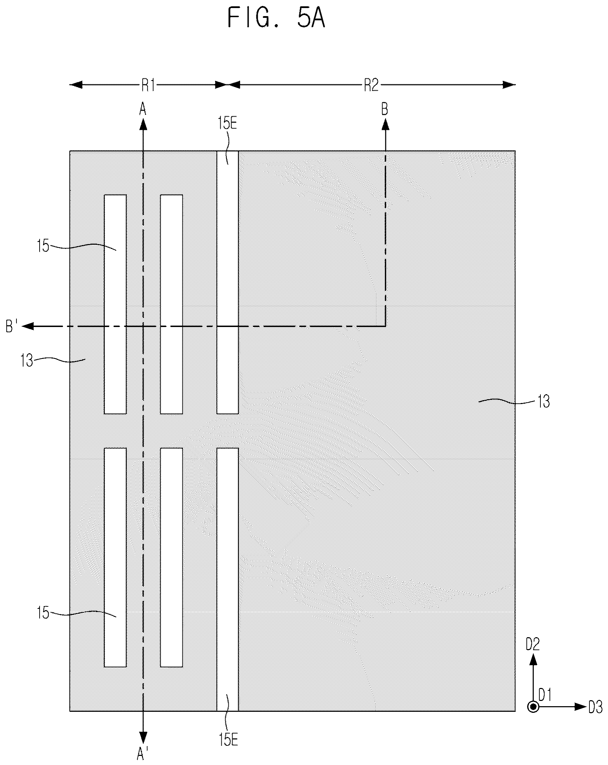

FIGS. 5A to 34B illustrate various views of a semiconductor device formed by a method for fabricating the semiconductor device in accordance with an embodiment of the present disclosure.

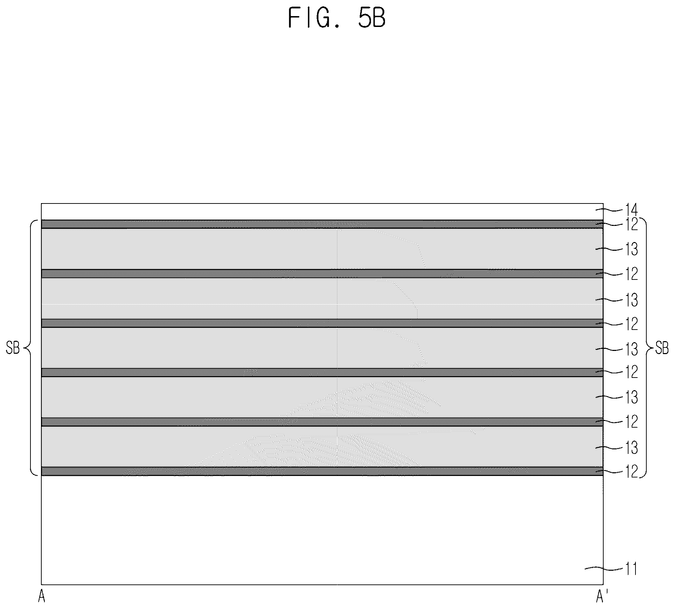

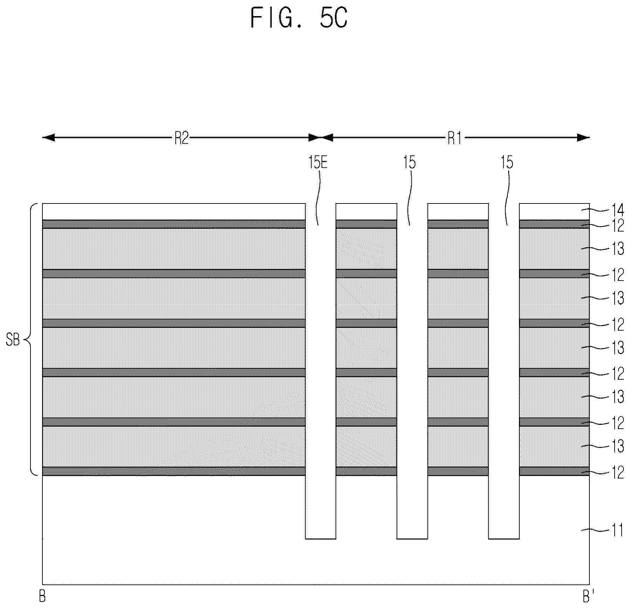

FIG. 5A is a plan view illustrating a structure at a second mold layer level for describing a method for forming a mold stack SB. FIG. 5B is a cross-sectional view of the structure taken along line A-A' illustrated in FIG. 5A. FIG. 5C is a cross-sectional view of the structure taken along line B-B' illustrated in FIG. 5A.

Referring to FIGS. 5A to 5C, the mold stack SB may be formed over or on a substrate 11. The mold stack SB may include an alternating stack of first mold layers 12 and second mold layers 13. In the illustrated embodiment, the lowermost and uppermost layers are first mold layers 12.

To form the mold stack SB, the first mold layers 12 may be alternately stacked with the second mold layers 13. The first mold layers 12 and the second mold layers 13 may be grown multiple times. The first mold layers 12 and the second mold layers 13 may be grown epitaxially multiple times.

The first mold layers 12 and the second mold layers 13 may be different semiconductive materials. For example, the first mold layers 12 may each include silicon germanium or monocrystalline silicon germanium, while the second mold layers 13 may each include monocrystalline silicon. The first mold layers 12 and the second mold layers 13 may be formed by an epitaxial growth process. A lowermost first mold layer 12 may serve as a seed layer during the epitaxial growth process. Each of the first mold layers 12 may be thinner than each of the second mold layers 13. The first mold layers 12 may include first epitaxially grown layers, and the second mold layers 13 may include second epitaxially grown layers.

In an embodiment, a plurality of monocrystalline silicon germanium layers may be alternately stacked with a plurality of monocrystalline silicon layers in the mold stack SB. For example, the first mold layers 12 may be the monocrystalline silicon germanium layers, and the second mold layers 13 may be the monocrystalline silicon layers. A stack of a monocrystalline silicon germanium layer and a monocrystalline silicon layer (a SiGe/Si stack) may be stacked multiple times. The first mold layers 12 may be referred to as "sacrificial layers", and the second mold layers 13 may be referred to as "nano sheet target layers" or "recess nano sheet target layers".

The mold stack SB may be referred to as a "vertical stack". The mold stack SB may be formed by alternately stacking a plurality of sacrificial layers 12 and a plurality of nano sheet target layers 13. The sacrificial layers 12 may be monocrystalline silicon germanium layers, and the nano sheet target layers 13 may be monocrystalline silicon layers.

A thickness ratio of the first mold layers 12 and a thickness ratio of the second mold layers 13 in the mold stack SB may be variously modified. For example, the thickness of the first mold layers 12 may be 5 to 20 nm, and the thickness of the second mold layers 13 may be 50 to 80 nm.

A quantity of the first mold layers 12 and a quantity of the second mold layers 13 in the mold stack SB may also be variously modified. In some embodiments, a triple stack including the first mold layer 12, the second mold layer 13 and the first mold layer 12 may be defined at lowermost and/or uppermost portions of the mold stack SB. The second mold layer 13 of the triple stack may have a thickness less than the second mold layer 13 of the mold stack SB.

A first hard mask layer 14 may be formed on the mold stack SB. The first hard mask layer 14 may include a dielectric material such as an oxide-based material, a nitride-based material, a carbon-based material, or a combination thereof. For example, the first hard mask layer 14 may include silicon oxide (SiO₂), silicon nitride (Si₃N₄), amorphous carbon, or a combination thereof.

Subsequently, portions of the mold stack SB may be etched using the first hard mask layer 14 as a barrier, and a plurality of sacrificial isolation openings 15 may be formed. The sacrificial isolation openings 15 may be initial openings for cell isolation. The sacrificial isolation openings may pass through the mold stack SB and extent partially into the substrate 11. From the perspective of a top view, cross-sections of the sacrificial isolation openings 15 may each have a rectangular shape. However, may not be limited in this way. For example, in some embodiments, the cross-sections of the sacrificial isolation openings 15 may each have a circular shape, and in other embodiments, the cross-sections of the sacrificial isolation openings 15 may each have an oval shape. In some embodiments, the sacrificial isolation openings 15 may be referred to as "sacrificial isolation trenches". The sacrificial isolation openings 15 may vertically extend in the first direction D1 and extend lengthwise in the second direction D2. The sacrificial isolation openings 15 may be disposed at a predetermined interval in the third direction D3. A bottom surface of each of the sacrificial isolation openings 15 may extend inside of the substrate 11. A bottom surface of each of the sacrificial isolation openings 15 may be flat.

Edge sacrificial isolation openings 15E may be formed while the sacrificial isolation openings 15 are formed. A length of each of the edge sacrificial isolation openings 15E in the second direction D2 may be greater than a length of each of the sacrificial isolation openings 15 as can be better seen in FIG. 5A.

The sacrificial isolation openings 15 may be formed in a first region R1, and the edge sacrificial isolation openings 15E may be formed at a boundary portion between the first region R1 and a second region R2.

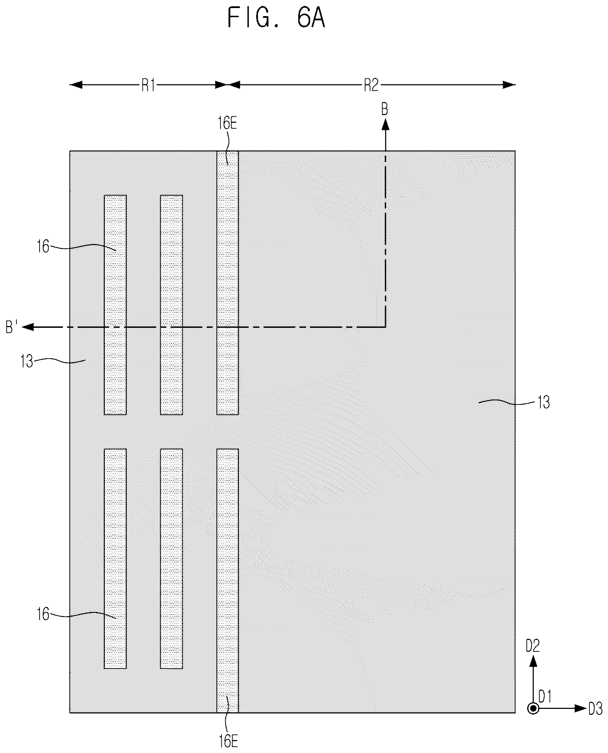

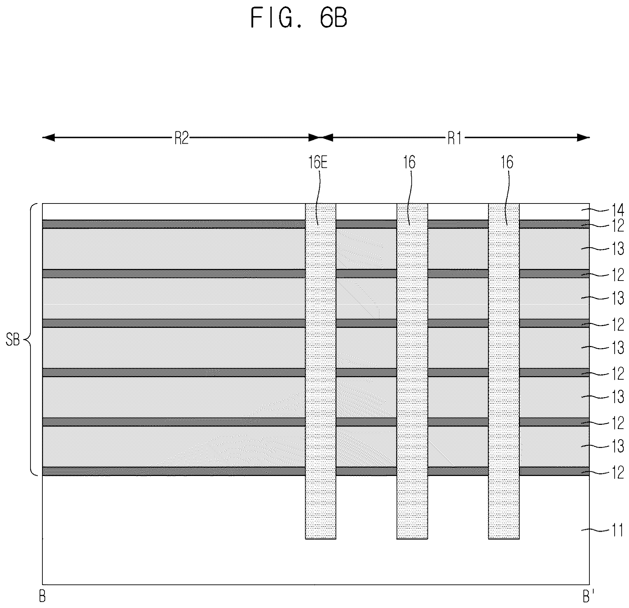

FIG. 6A is a plan view illustrating the structure at the second mold layer level for describing a method for forming sacrificial isolation layers 16. FIG. 6B is a cross-sectional view of the structure taken along line B-B' illustrated in FIG. 6A.

Referring to FIGS. 6A and 6B, the sacrificial isolation layers 16 may be formed by filling the sacrificial isolation openings 15 with a dielectric material. The sacrificial isolation layers 16 may include the same dielectric material. The sacrificial isolation layers 16 may have an etch selectivity with respect to the mold stack SB. For example, the sacrificial isolation layers 16 may each include, silicon oxide, silicon nitride, silicon carbon oxide, silicon carbon nitride, or a combination thereof. Forming the sacrificial isolation layers 16 may include forming sacrificial isolation materials on the mold stack SB to fill the sacrificial isolation openings 15 and planarizing the sacrificial isolation materials so that a surface of the first hard mask layer 14 is exposed.

The sacrificial isolation layers 16 may vertically extend in the first direction D1 and may also extend lengthwise in the second direction D2. The sacrificial isolation layers 16 may be disposed at a predetermined interval in the third direction D3. In an embodiment, each of the sacrificial isolation layers 16 may include a stack of a first sacrificial liner layer and a first sacrificial gap-fill layer. The first sacrificial liner layer may be silicon nitride, and the first sacrificial gap-fill layer may be silicon oxide. The sacrificial isolation layers 16 may pass through the mold stack SB in the first direction D1.

Edge sacrificial isolation layers 16E may be formed while the sacrificial isolation layers 16 are formed. A length of each of the edge sacrificial isolation layers 16E in the second direction D2 may be greater than a length of each of the sacrificial isolation layers 16.

The sacrificial isolation layers 16 may be formed in the first region R1, and the edge sacrificial isolation layers 16E may be formed at the boundary portion between the first region R1 and the second region R2 as illustrated in FIG. 6A

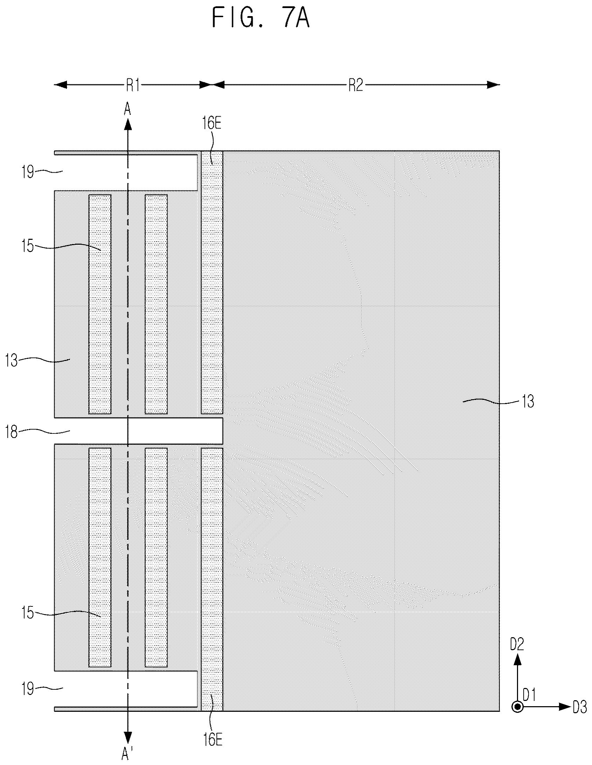

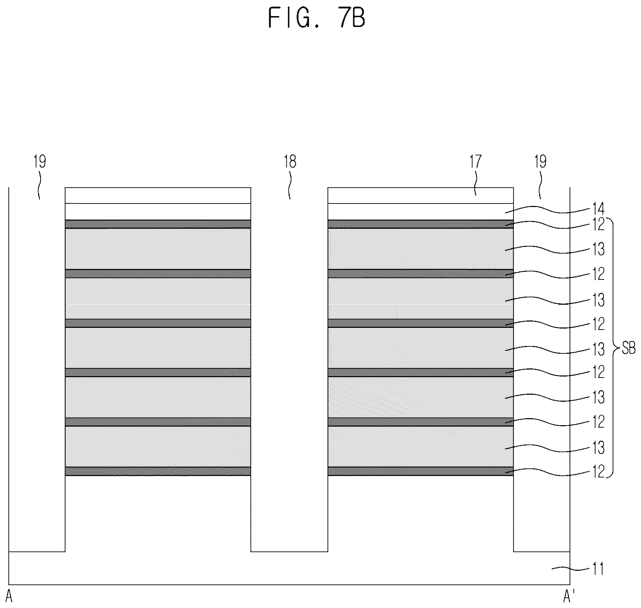

FIG. 7A is a plan view illustrating the structure at the second mold layer level for describing a method for forming sacrificial linear openings 18 and 19. FIG. 7B is a cross-sectional view of the structure taken along line A-A' illustrated in FIG. 7A.

Referring to FIGS. 7A and 7B, a second hard mask layer 17 may be formed on the mold stack SB and the sacrificial isolation layers 16. For example, the second hard mask layer 17 may include silicon nitride. The second hard mask layer 17 may be formed by etching a second hard mask material using a mask layer such as photoresist. The second hard mask layer 17 may have a plurality of line-shaped openings defined therein.

Portions of the mold stack SB may be etched using the second hard mask layer 17 as an etch barrier. Accordingly, a plurality of sacrificial linear openings 18 and 19 may be formed between the sacrificial isolation layers 16. The sacrificial linear openings may include a first sacrificial linear opening 18 and a second sacrificial linear opening 19. From the perspective of a top view, the first sacrificial linear opening 18 and the second sacrificial linear opening 19 may be line-shaped openings extending in the third direction D3. The first sacrificial linear opening 18 and the second sacrificial linear opening 19 may vertically extend in the first direction D1. The sacrificial isolation layers 16 may be disposed between the first sacrificial linear opening 18 and the second sacrificial linear opening 19 in the second direction D2. From the perspective of a top view, cross sections of the first and second sacrificial linear openings 18 and 19 may each have a rectangular shape. In some embodiments, the cross sections of the first and second sacrificial linear openings 18 and 19 may each have a circular shape or an oval shape. The first and second sacrificial linear openings 18 and 19 may each have a width in the second direction D2 which is less than a width in the third direction D3. The first and second sacrificial linear openings 18 and 19 may be referred to as "sacrificial linear trenches". The sacrificial isolation layers 16 may not contact the first and second sacrificial linear openings 18 and 19. The first and second sacrificial linear openings 18 and 19 may have different horizontal lengths in the third direction D3.

One end of the first sacrificial linear opening 18 may extend to be disposed between the edge sacrificial isolation layers 16E as shown in FIG. 7A.

All of the first and second sacrificial linear openings 18 and 19 may be formed in the first region R1.

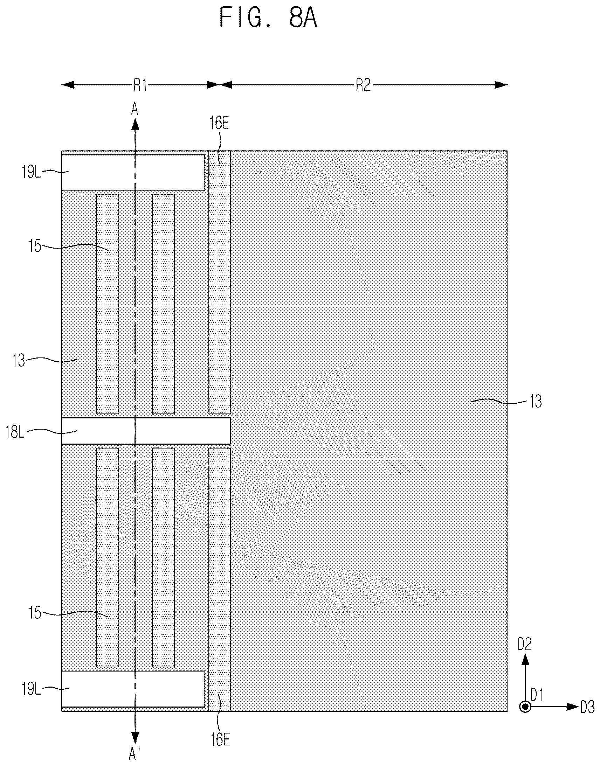

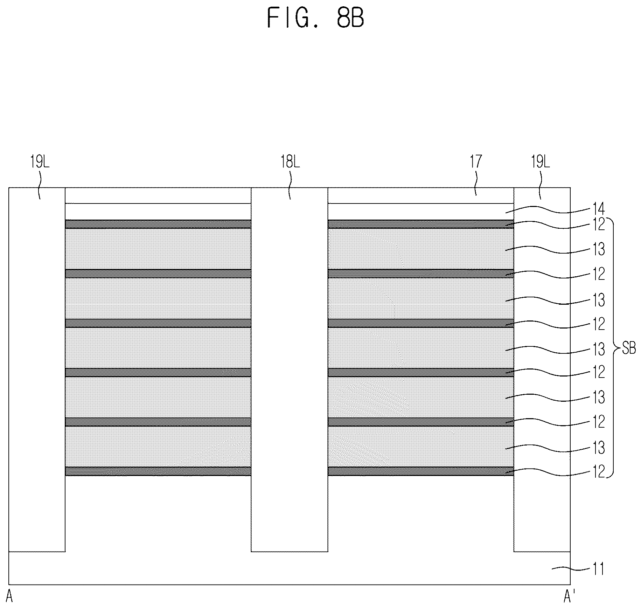

FIG. 8A is a plan view illustrating the structure at the second mold layer level for describing a method for forming linear sacrificial layers 18L and 19L. FIG. 8B is a cross-sectional view of the structure taken along line A-A' illustrated in FIG. 8A.

Referring to FIGS. 8A and 8B, the linear sacrificial layers 18L and 19L may be formed to fill the first and second sacrificial linear openings 18 and 19. The linear sacrificial layers may include a first linear sacrificial layer 18L and a second linear sacrificial layer 19L. From the perspective of a top view, the first linear sacrificial layer 18L and the second linear sacrificial layer 19L may have line shapes extending in the third direction D3. The first linear sacrificial layer 18L and the second linear sacrificial layer 19L may vertically extend in the first direction D1. The sacrificial isolation layers 16 may be disposed between the first linear sacrificial layer 18L and the second linear sacrificial layer 19L in the second direction D2. From the perspective of a top view, cross sections of the first and second linear sacrificial layers 18L and 19L may each have a rectangular shape. In some embodiments, the cross-sections of the first and second linear sacrificial layers 18L and 19L may each have a circular shape or an oval shape. The first and second linear sacrificial layers 18L and 19L may include the same material. The first and second linear sacrificial layers 18L and 19L may each include a dielectric material. For example, the first and second linear sacrificial layers 18L and 19L may each include, for example, silicon oxide, silicon nitride, silicon carbon oxide, silicon carbon nitride, or a combination thereof. The sacrificial isolation layers 16 may not contact the first and second linear sacrificial layers 18L and 19L.

One end of the first linear sacrificial layer 18L may extend to be disposed between the edge sacrificial isolation layers 16E.

All of the first and second linear sacrificial layers 18L and 19L may be formed in the first region R1.

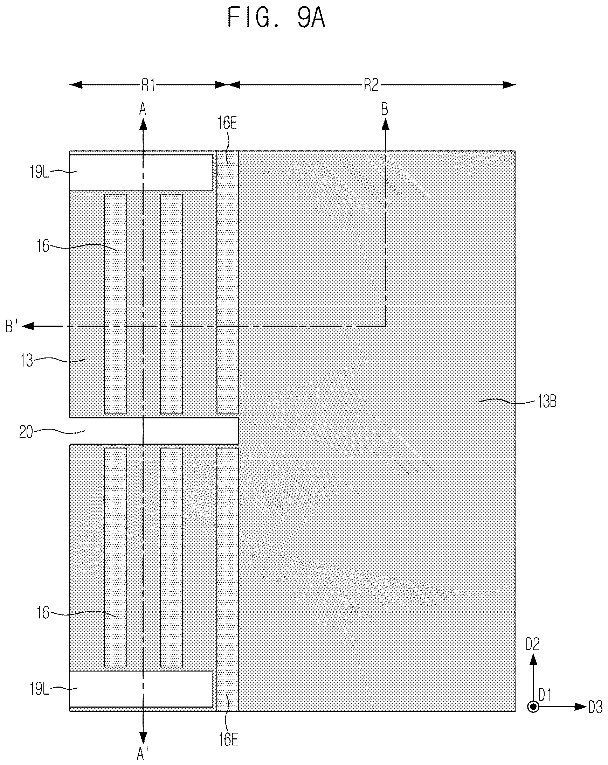

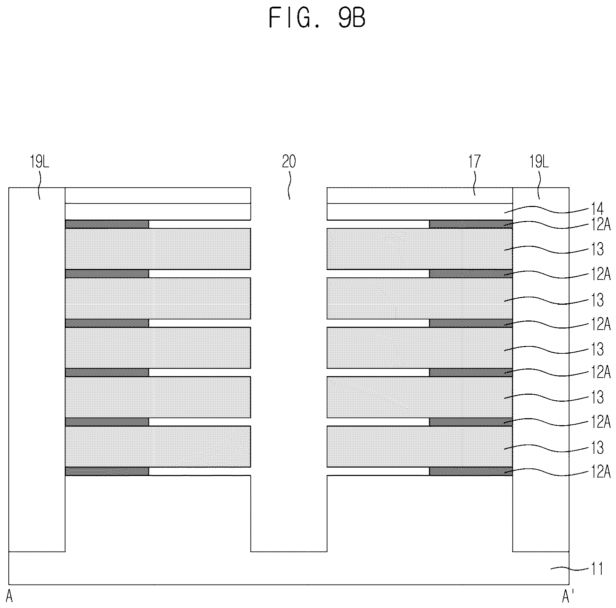

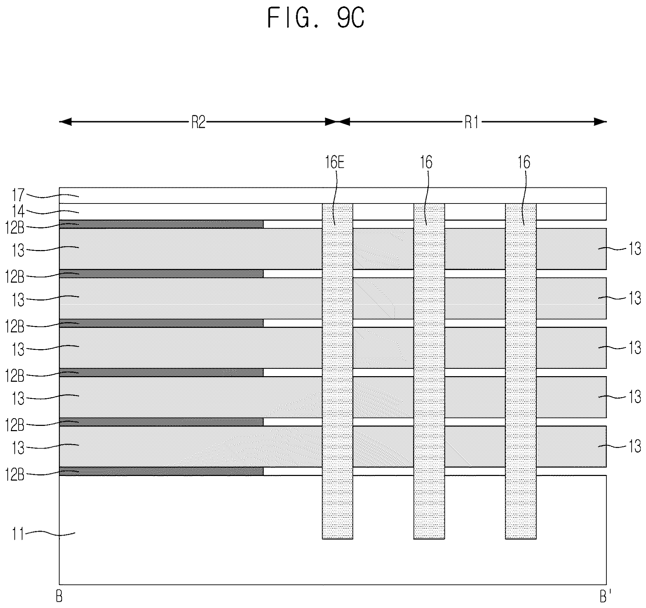

FIG. 9A is a plan view illustrating the structure at the second mold layer level to describe recessing of the first mold layers 12. FIG. 9B is a cross-sectional view of the structure taken along line A-A' illustrated in FIG. 9A. FIG. 9C is a cross-sectional view of the structure taken along line B-B' illustrated in FIG. 9A.

Referring to FIGS. 9A to 9C, among the first linear sacrificial layer 18L and the second linear sacrificial layer 19L, the first linear sacrificial layer 18L may be selectively removed to form a first linear opening 20. From the perspective of a top view, the first linear opening 20 may be disposed horizontally spaced apart from the second linear sacrificial layer 19L in the second direction D2.

Referring to FIG. 9B, the first mold layers 12 may be selectively recessed through the first linear opening 20.

A difference in etch selectivity between the first mold layers 12 and the second mold layers 13 may be used to selectively recess the first mold layers 12. The first mold layers 12 may be removed using a wet etch process or a dry etch process. For example, when the first mold layers 12 include silicon germanium layers, and the second mold layers 13 include monocrystalline silicon layers, the silicon germanium layers may be etched using an etchant or etch gas having a selectivity with respect to the monocrystalline silicon layers. The remaining first mold layers each having an original thickness may remain as indicated by reference numeral "12A". The remaining first mold layers 12A may remain in the first region R1, and pad-side first mold layers 12B may remain in the second region R2.

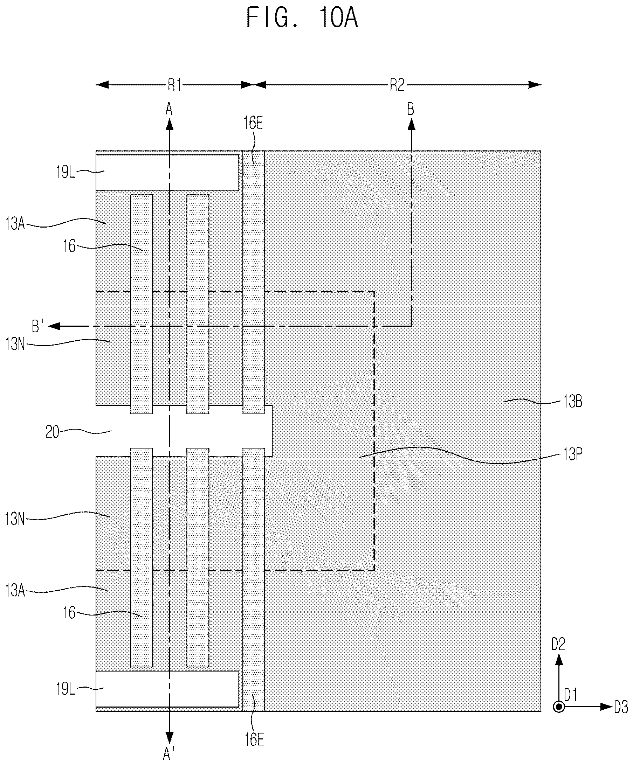

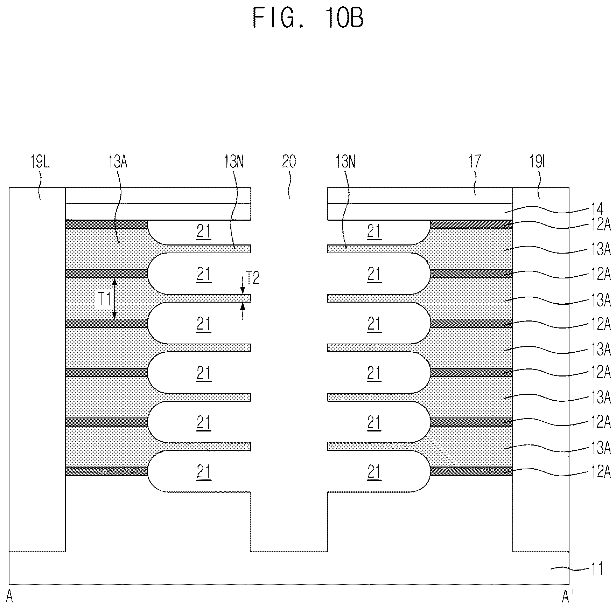

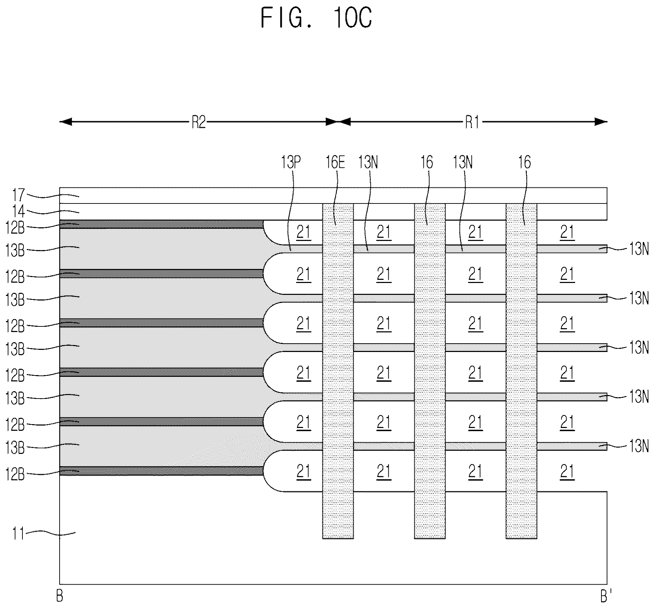

FIG. 10A is a plan view illustrating the structure at the second mold layer level to describe recessing of the second mold layers 13. FIG. 10B is a cross-sectional view of the structure taken along line A-A' illustrated in FIG. 10A. FIG. 10C is a cross-sectional view of the structure taken along line B-B' illustrated in FIG. 10A.

Referring to FIGS. 10A to 10C, a portion (a first portion) of each of the second mold layers 13 may be recessed to form a narrow nano sheet 13N. The wet etch process or dry etch process may be used to recess the second mold layers 13. An original body portion 13A and the narrow nano sheet 13N may be formed by the partial recessing of each of the second mold layers 13. The original body portion 13A may maintain an original thickness T1, and the narrow nano sheet 13N may have a thickness T2 which is less than the original thickness T1. A horizontal length of the original body portion 13A in the second direction D2 may be equal to or different from a horizontal length of the narrow nano sheet 13N in the second direction D2. A combination of the original body portion 13A and the narrow nano sheet 13N may be referred to as a "preliminary active layer". The narrow nano sheet 13N may also be referred to as a "flat plate-shaped sheet" or a "protruding narrow nano sheet".

A recess process for forming the narrow nano sheet 13N may be referred to as a "thinning process" or "trimming process" of the second mold layer 13. To form the narrow nano sheet 13N, an upper surface, lower surface and side surface of the second mold layer 13 may be recessed. The narrow nano sheet 13N may be referred to as a "thin-body active layer". The narrow nano sheet 13N may include a monocrystalline silicon layer. The recess process for forming the narrow nano sheet 13N may use, for example, Hot SC-1 (HSC1). The HSC1 may include a solution in which ammonium hydroxide (NH₄OH), hydrogen peroxide (H₂O₂) and water (H₂O) are mixed in a ratio of 1:4:20. Using the HSC1, the second mold layers 13 may be selectively etched.

The narrow nano sheets 13N may be formed in the first region R1 by the partial recess process for the second mold layers 13 as described above. An inter-nano sheet recess 21 may be formed between the narrow nano sheets 13N that are vertically disposed. Upper and lower surfaces of each of the narrow nano sheets 13N may each include a flat surface. A boundary portion between the original body portion 13A and the narrow nano sheet 13N may be vertical or have a curvature. Each of the first mold layers 12A may be disposed between two original body portions 13A that are vertically stacked.

The narrow nano sheets 13N may be formed in the first region R1, and pad-side narrow nano sheets 13P may be formed in the second region R2 while the narrow nano sheets 13N are formed.

The original body portions 13A may remain in the first region R1, and pad-side second mold layers 13B may remain in the second region R2.

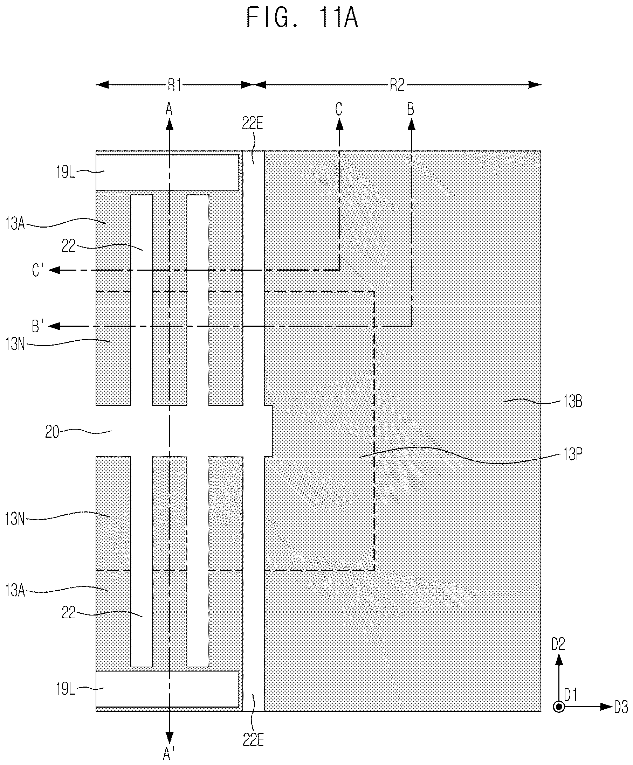

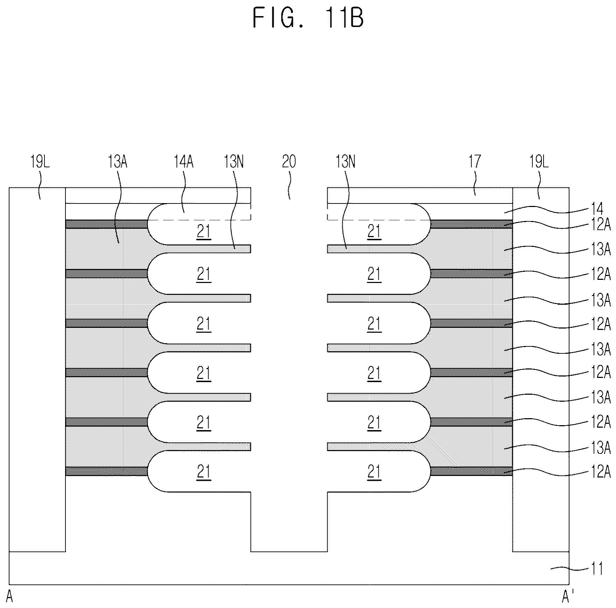

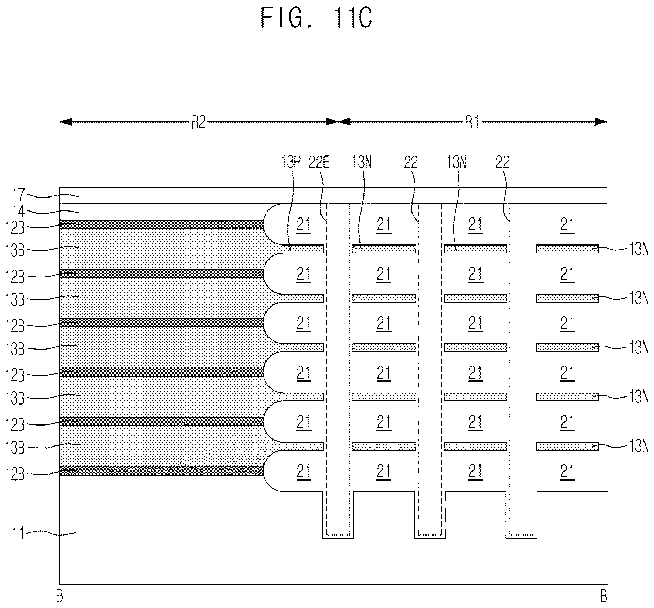

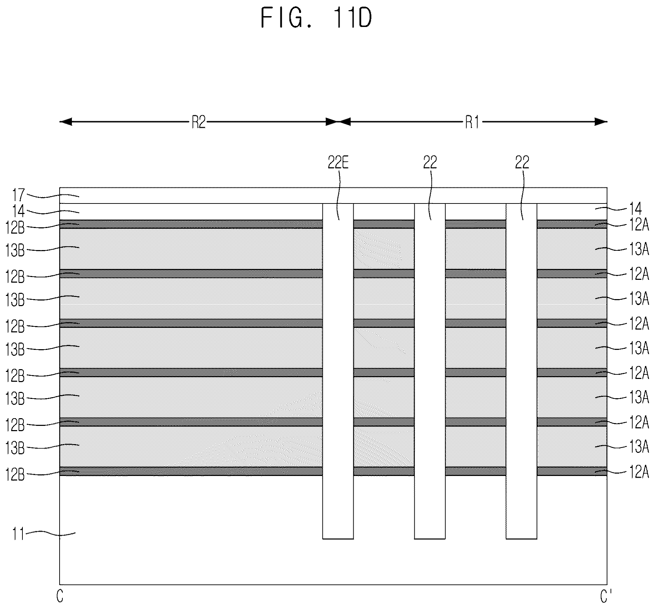

FIG. 11A is a plan view illustrating the structure at a narrow nano sheet level for describing a method for forming sacrificial isolation layer-level openings 22. FIG. 11B is a cross-sectional view of the structure taken along line A-A' illustrated in FIG. 11A. FIG. 11C is a cross-sectional view of the structure taken along line B-B' illustrated in FIG. 11A. FIG. 11D is a cross-sectional view of the structure taken along line C-C' illustrated in FIG. 11A.

Referring to FIGS. FIGS. 11A to 11D, the sacrificial isolation layers 16 may be selectively stripped through the inter-nano sheet recesses 21. Accordingly, each of the sacrificial isolation layer-level openings 22 may be formed between the original body portions 13A in the third direction D3.

Side surfaces of the first mold layers 12A, side surfaces of the original body portions 13A and side surfaces of the narrow nano sheets 13N may be exposed in the third direction D3 by the sacrificial isolation layer-level openings 22.

While the sacrificial isolation layer-level openings 22 are formed, a portion of the first hard mask layer 14 (refer to reference numeral "14A" of FIG. 11B) may be recessed. Accordingly, a space of an uppermost inter-nano sheet recess 21 may be expanded.

While the sacrificial isolation layer-level openings 22 are formed, the edge sacrificial isolation layers 16E may be removed. Accordingly, edge sacrificial isolation layer-level openings 22E may be formed.

The sacrificial isolation layer-level openings 22 may be formed in the first region R1, and the edge sacrificial isolation layer-level openings 22E may be formed at the boundary portion between the first region R1 and the second region R2.

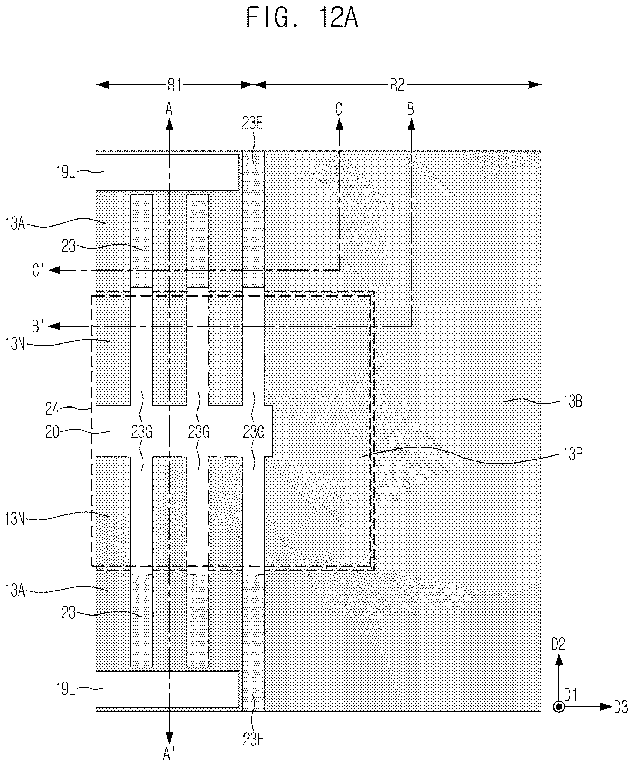

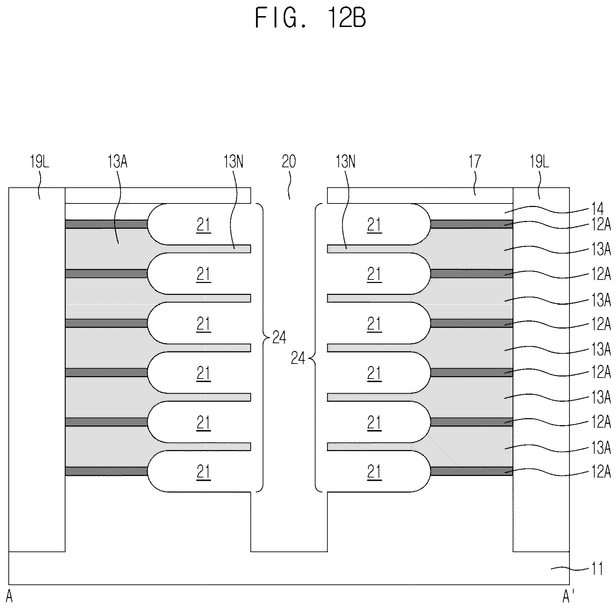

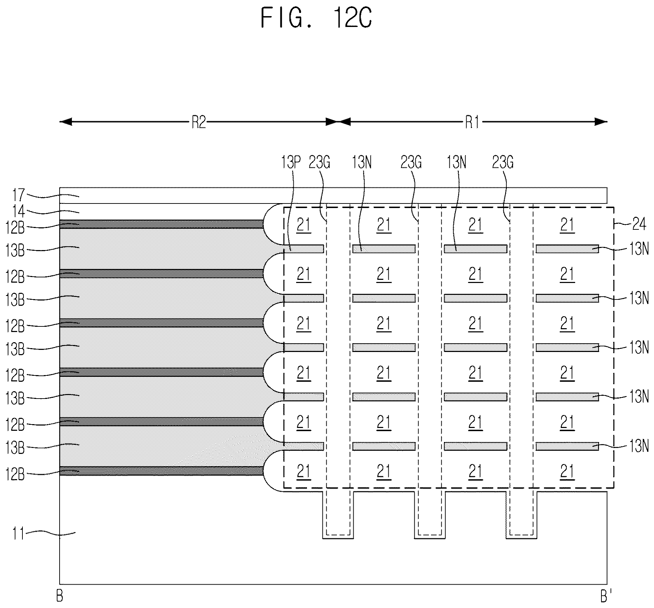

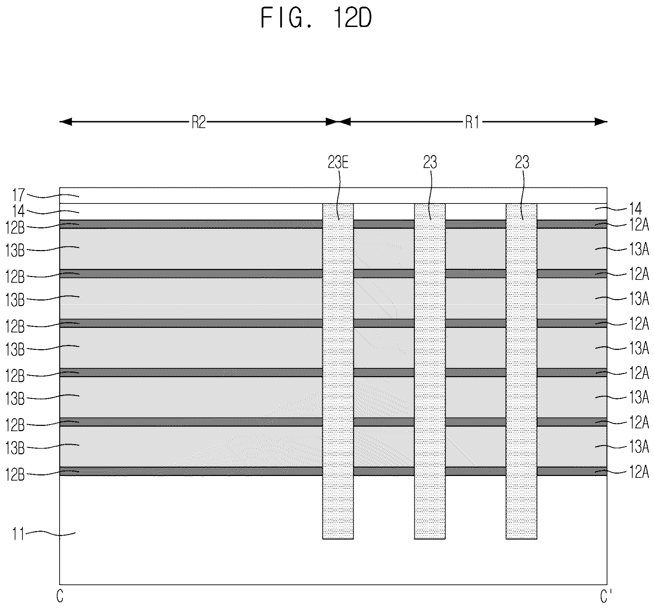

FIG. 12A is a plan view illustrating the structure at the narrow nano sheet level for describing a method for forming first inter-cell dielectric layers 23. FIG. 12B is a cross-sectional view of the structure taken along line A-A' illustrated in FIG. 12A. FIG. 12C is a cross-sectional view of the structure taken along line B-B' illustrated in FIG. 12A. FIG. 12D is a cross-sectional view of the structure taken along line C-C' illustrated in FIG. 12A.

Referring to FIGS. 12A to 12D, the first inter-cell dielectric layers 23 may be formed in the sacrificial isolation layer-level openings 22. The first inter-cell dielectric layers 23 may each include a dielectric material. The first inter-cell dielectric layers 23 may each include, for example, silicon oxide, silicon nitride, silicon carbon oxide, or a combination thereof. Forming the first inter-cell dielectric layers 23 may include first forming a dielectric material that fills the sacrificial isolation layer-level openings 22 and then performing an etch-back process on the dielectric material so that the first inter-cell dielectric layers 23 may fill only portions of the sacrificial isolation layer-level openings 22.The first inter-cell dielectric layers 23 may fill portions of the sacrificial isolation layer-level openings 22 and the side surfaces of the first mold layers 12A and the side surfaces of the original body portions 13A may be covered by the first inter-cell dielectric layers 23 in the third direction D3. The first inter-cell dielectric layers 23 may expose the side surfaces of the narrow nano sheets 13N. The other portions of the sacrificial isolation layer-level openings 22, i.e., non-gap-filled portions 23G, may expose the side surfaces of the narrow nano sheets 13N. The non-gap-filled portions 23G may be defined between the narrow nano sheets 13N in the third direction D3.

After the first inter-cell dielectric layers 23 are formed, a nano sheet all-open recess 24 that opens all of the narrow nano sheets 13N may be formed. The nano sheet all-open recess 24 refers to a combination of the inter-nano sheet recesses 21 and the non-gap-filled portions 23G of the sacrificial isolation layer-level openings 22. The nano sheet all-open recess 24 may expose all of the narrow nano sheets 13N in the third direction D3. The nano sheet all-open recess 24 may also expose all of the pad-side narrow nano sheets 13P.

While the first inter-cell dielectric layers 23 are formed, edge first inter-cell dielectric layers 23E may be formed.

The first inter-cell dielectric layers 23 may be formed in the first region R1. The edge first inter-cell dielectric layers 23E may be formed at the boundary portion between the first region R1 and the second region R2.

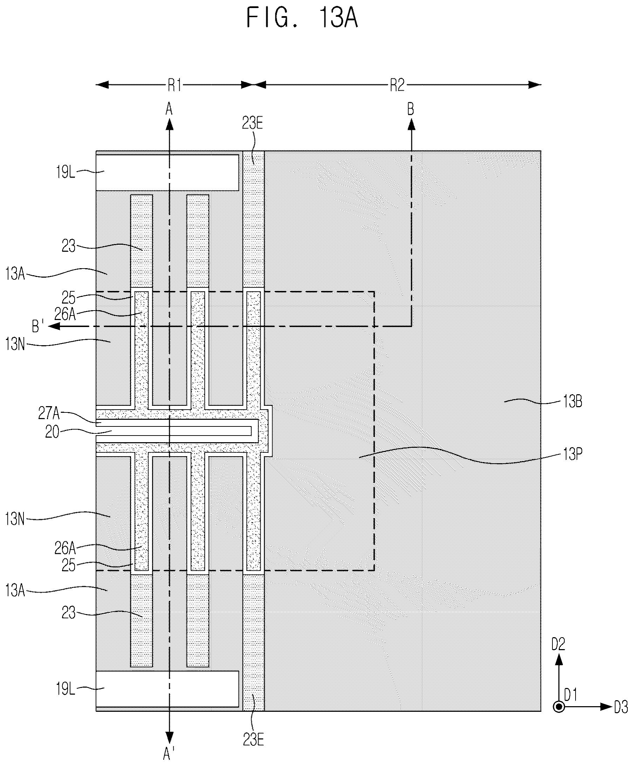

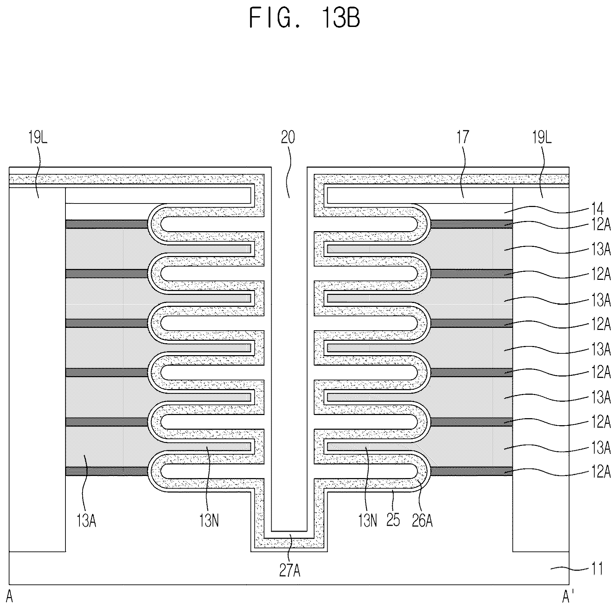

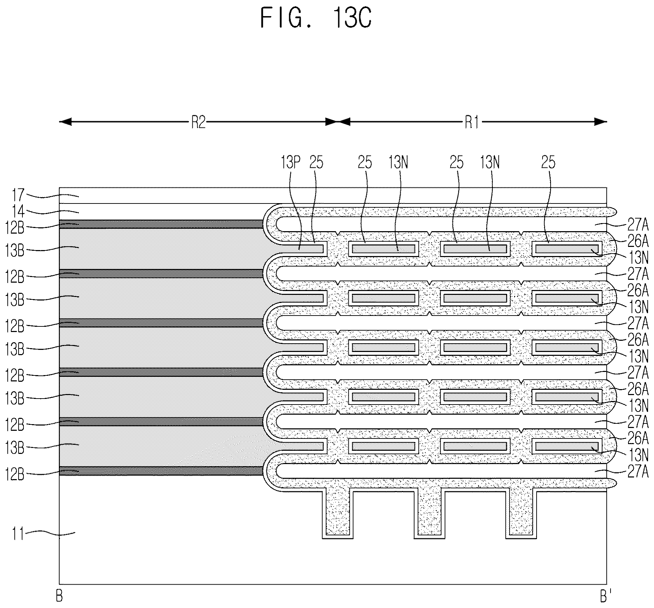

FIG. 13A is a plan view illustrating the structure at the narrow nano sheet level for describing a method for forming a first spacer layer 26A. FIG. 13B is a cross-sectional view of the structure of FIG. 13A taken along line A-A' illustrated in FIG. 13A. FIG. 13C is a cross-sectional view of the structure of FIG. 13A taken along line B-B' illustrated in FIG. 13A.

Referring to FIGS. 13A to 13C, a nano sheet dielectric layer 25 may be formed on the exposed portions of the narrow nano sheets 13N. The nano sheet dielectric layer 25 may also be referred to as a "gate dielectric layer".

The nano sheet dielectric layer 25 may be formed by oxidizing the surfaces of the narrow nano sheets 13N. In some embodiments, the nano sheet dielectric layer 25 may be formed by deposition and oxidation processes of silicon oxide. The nano sheet dielectric layer 25 may include, for example, silicon oxide, silicon nitride, metal oxide, metal oxide nitride, metal silicate, a high-k material, a ferroelectric material, an anti-ferroelectric material, or a combination thereof. The nano sheet dielectric layer 25 may include silicon dioxide (SiO₂), silicon nitride (Si₃N₄), hafnium oxide (HfO₂), aluminum oxide (Al₂O₃), zirconium oxide (ZrO₂), aluminum oxynitride (AlON), hafnium oxynitride (HfON), hafnium silicon oxide (HfSiO), hafnium silicon oxynitride (HfSiON), or a combination of these materials. The nano sheet dielectric layer 25 may be formed on all surfaces of the narrow nano sheets 13N.

The first spacer layer 26A may be formed on the nano sheet dielectric layer 25. For example, the first spacer layer 26A may include silicon nitride. The first spacer layer 26A may surround and cover the narrow nano sheets 13N on the nano sheet dielectric layer 25. The first spacer layer 26A may be thicker than the nano sheet dielectric layer 25.

Second inter-cell dielectric layers 27A may be formed on the first spacer layer 26A. The second inter-cell dielectric layers 27A may each include, for example, silicon oxide.

The nano sheet dielectric layer 25 and the first spacer layer 26A may also be formed on the surface of the substrate 11.

As described above, the first spacer layer 26A may be disposed between the narrow nano sheets 13N in the third direction D3.

The nano sheet dielectric layer 25, the first spacer layer 26A and the second inter-cell dielectric layers 27A may be formed in the first region R1.

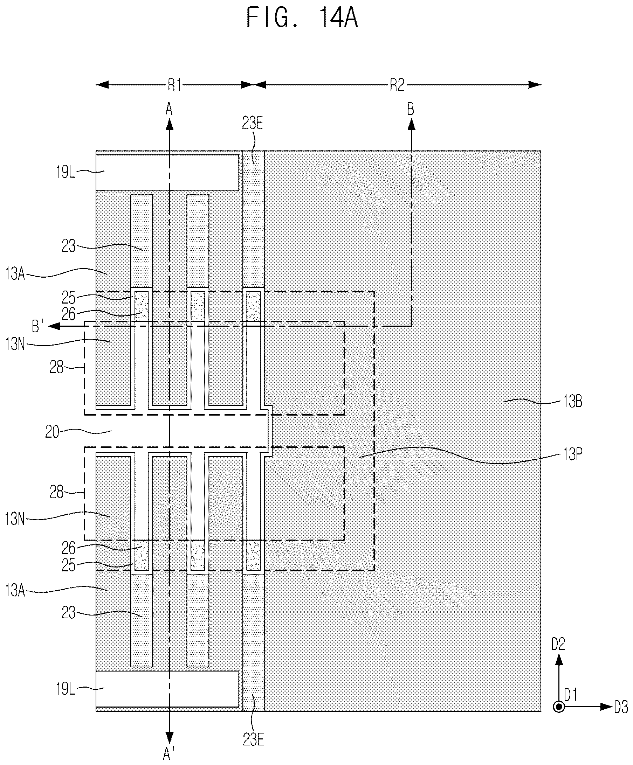

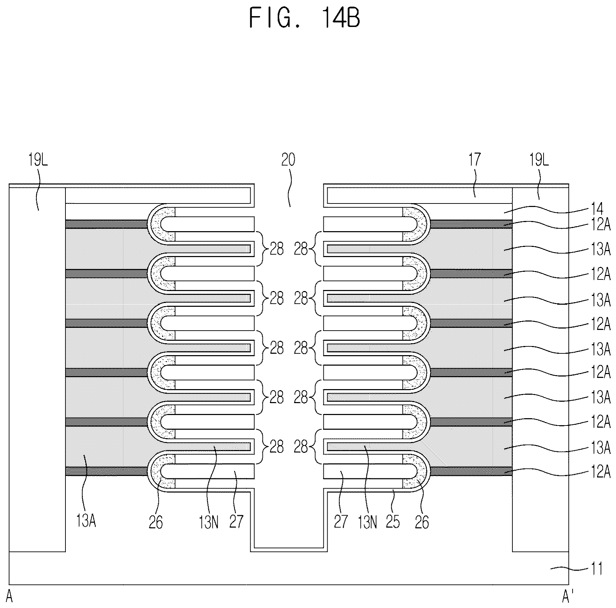

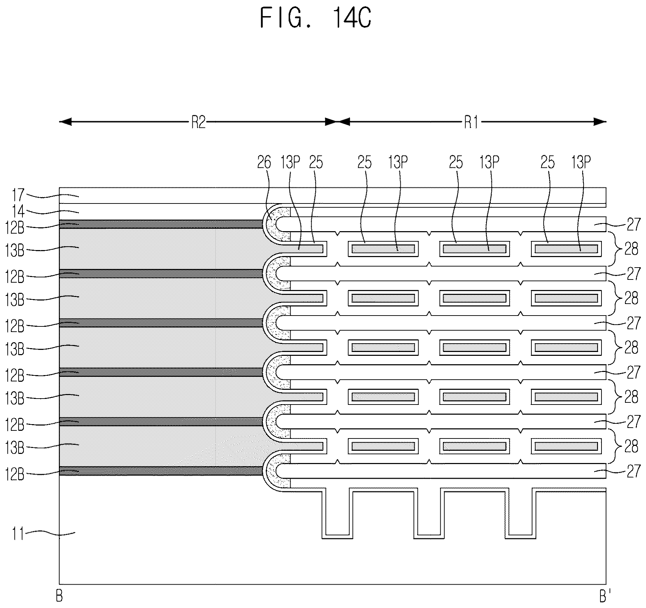

FIG. 14A is a plan view illustrating the structure at the narrow nano sheet level for describing a method for forming first spacers 26. FIG. 14B is a cross-sectional view of the structure taken along line A-A' illustrated in FIG. 14A. FIG. 14C is a cross-sectional view of the structure taken along line B-B' illustrated in FIG. 14A.

Referring to FIGS. 14A to 14C, the second inter-cell dielectric layers 27A may be cut through the first linear opening 20. Subsequently, the first spacer layer 26A may be selectively recessed. The remaining first spacer layers may become the first spacers 26, and the second inter-cell dielectric layers may remain as indicated by reference numeral "27".

As the first spacers 26 are formed, linear surrounding recesses 28 surrounding the narrow nano sheets 13N may be formed on the nano sheet dielectric layer 25. Each of the second inter-cell dielectric layers 27 may be disposed between the linear surrounding recesses 28 that are vertically disposed.

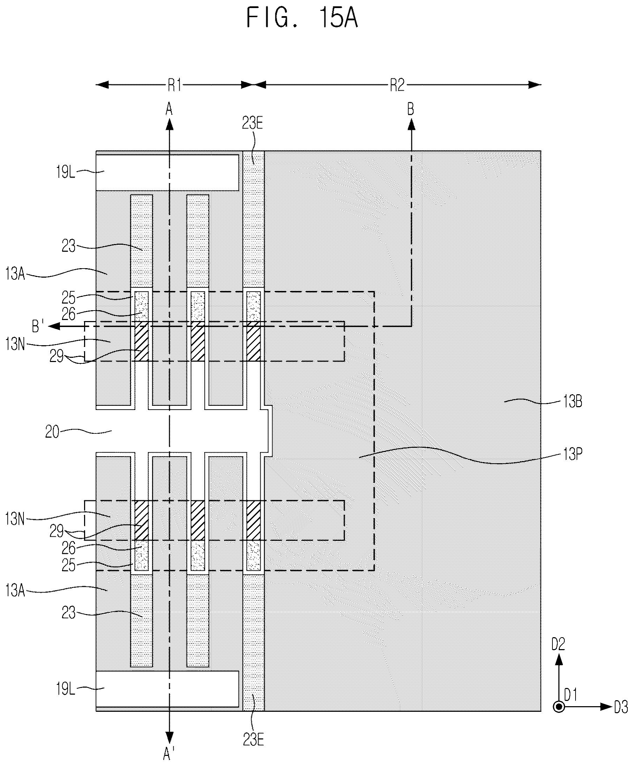

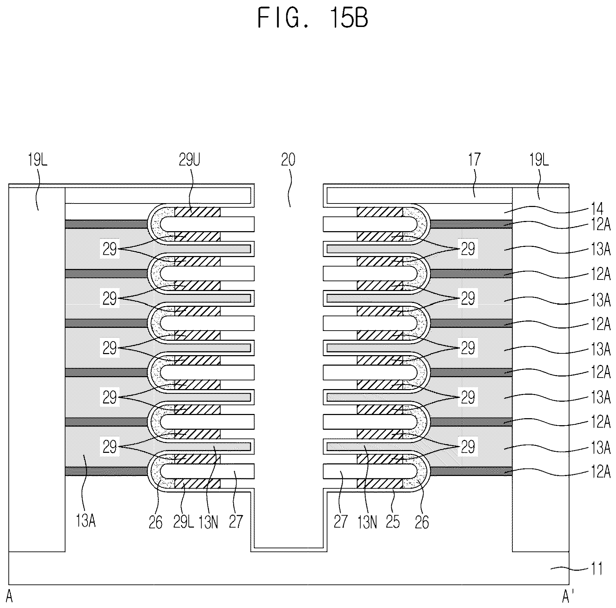

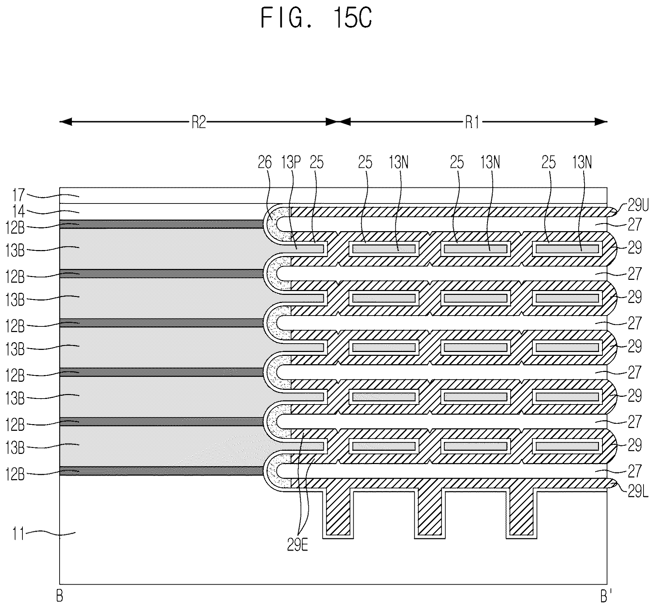

FIG. 15A is a plan view illustrating the structure at the narrow nano sheet level for describing a method for forming horizontal conductive lines 29. FIG. 15B is a cross-sectional view of the structure taken along line A-A' illustrated in FIG. 15A. FIG. 15C is a cross-sectional view of the structure taken along line B-B' illustrated in FIG. 15A.

Referring to FIGS. 15A to 15C, the horizontal conductive lines 29 may be formed to fill the linear surrounding recesses 28. The horizontal conductive lines 29 may horizontally extend in the third direction D3.

Forming the horizontal conductive lines 29 may include first depositing a conductive material to fill the linear surrounding recesses 28 on the nano sheet dielectric layer 25 and then performing a horizontal etch-back process on the conductive material. Each of the horizontal conductive lines 29 may simultaneously surround the narrow nano sheets 13N at the same level. The horizontal conductive lines 29 may each include a metal-based material, a semiconductive material, or a combination thereof. The horizontal conductive lines 29 may each include molybdenum, molybdenum nitride, ruthenium, titanium nitride, tungsten, polysilicon, or a combination thereof. For example, the horizontal conductive lines 29 may each include a titanium nitride and tungsten (TiN/W) stack in which titanium nitride and tungsten are sequentially stacked. The horizontal conductive lines 29 may each include an N-type work function material or a P-type work function material. The N-type work function material may have a low work function of approximately 4.5 eV or less, and the P-type work function material may have a high work function of approximately 4.5 eV or greater. Each of the second inter-cell dielectric layers 27 may be disposed between a plurality of horizontal conductive lines 29 in the first direction D1. Each of the second inter-cell dielectric layers 27 may be disposed between each pair of horizontal conductive lines 29 that are adjacent in the first direction D1. The horizontal conductive lines 29 surrounding the narrow nano sheets 13N may be referred to as "gate-all-around (GAA) electrodes". The narrow nano sheets 13N may be referred to as "nano sheet channels", "nano wires" or "nano wire channels".

A lower-level dummy horizontal electrode 29L may be formed on the surface of the substrate 11. An upper-level dummy horizontal electrode 29U may be formed over an uppermost horizontal conductive line 29. The dummy horizontal electrodes 29L and 29U may each have a non-surrounding shape.

The horizontal conductive lines 29 may include edge portions 29E each having a concave shape. The edge portions 29E may extend to be disposed in the second region R2. The edge portions 29E of the horizontal conductive lines 29 may cover one side of the pad-side narrow nano sheets 13P on the nano sheet dielectric layer 25.

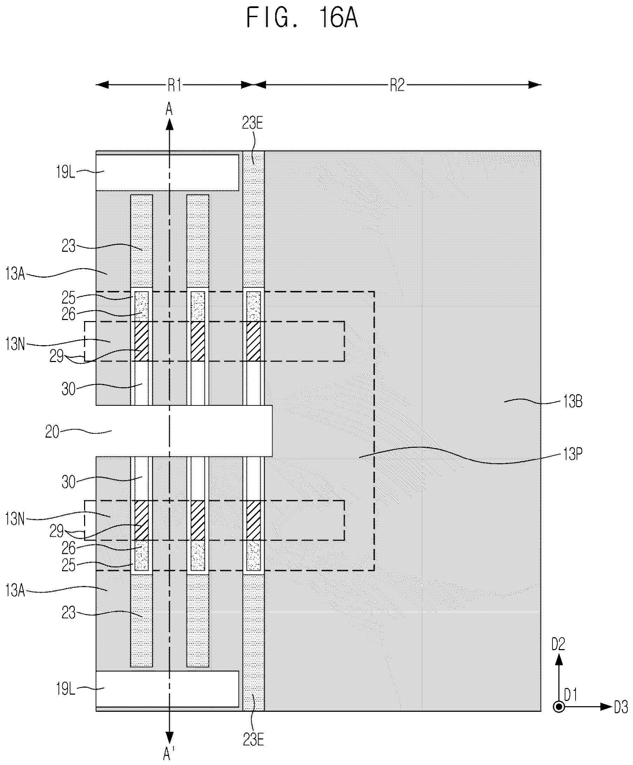

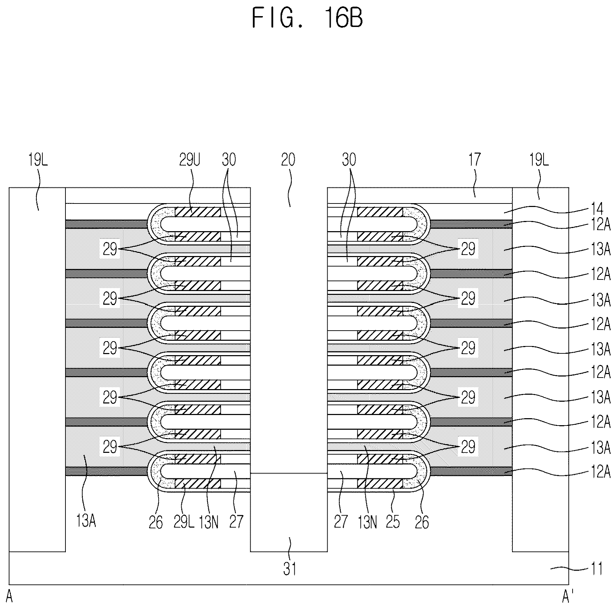

FIG. 16A is a plan view illustrating the structure at the narrow nano sheet level for describing a method for forming second spacers 30. FIG. 16B is a cross-sectional view of the structure taken along line A-A' illustrated in FIG. 16A.

Referring to FIGS. 16A and 16B, each of the second spacers 30 may be formed on one side of each of the horizontal conductive lines 29. The second spacer 30 may include, for example, silicon oxide, silicon nitride, silicon carbon oxide, an embedded air gap, or a combination thereof. Deposition and etch-back processes of a spacer material may be performed to form the second spacer 30. In an embodiment, the second spacer 30 may include a stack of a silicon oxide liner and a silicon nitride liner.

After the second spacers 30 are formed, a portion of the nano sheet dielectric layer 25 may be cut to expose one side of each of the narrow nano sheets 13N.

Subsequently, the deposition and etch-back processes may be performed on a first bottom passivation layer 31. An upper surface of the first bottom passivation layer 31 may be disposed at a level lower than a lowermost horizontal conductive line 29 and at a level higher than the lower-level dummy horizontal electrode 29L. The first bottom passivation layer 31 may include a dielectric material.

Each of the second spacers 30 may be disposed on one side of each of the horizontal conductive lines 29 and surround the narrow nano sheets 13N at the same horizontal level.

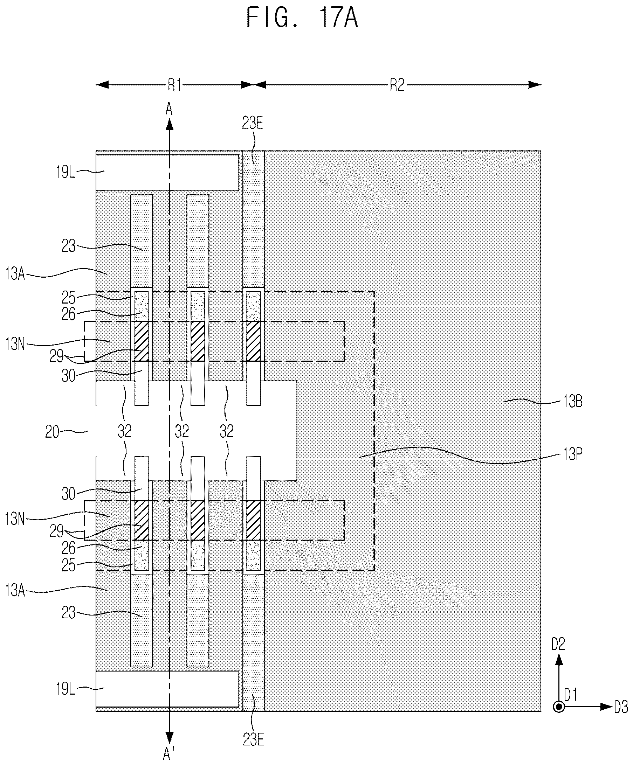

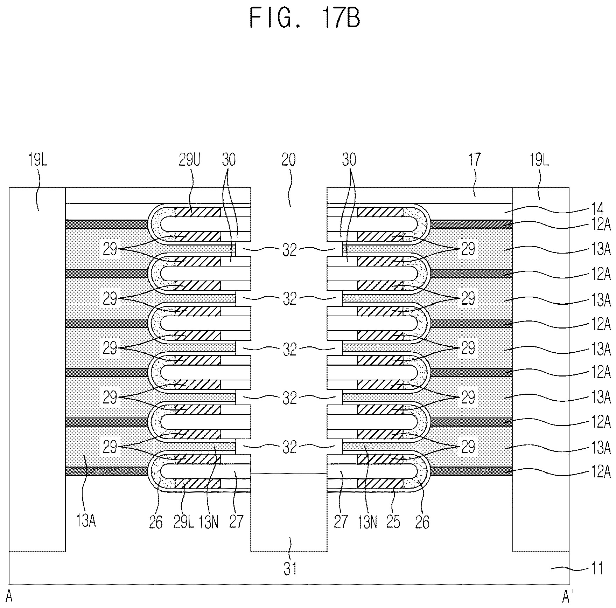

FIG. 17A is a plan view illustrating the structure at the narrow nano sheet level for describing a method for recessing the narrow nano sheets 13N. FIG. 17B is a cross-sectional view of the structure taken along line A-A' illustrated in FIG. 17A.

Referring to FIGS. 17A and 17B, the narrow nano sheets 13N may be horizontally recessed to form nano sheet level recesses 32. The nano sheet level recesses 32 may be defined in inner spaces of the second spacers 30 that are vertically stacked.

While the nano sheet level recesses 32 are formed, the pad-side narrow nano sheets 13P in the second region may also be partially recessed.

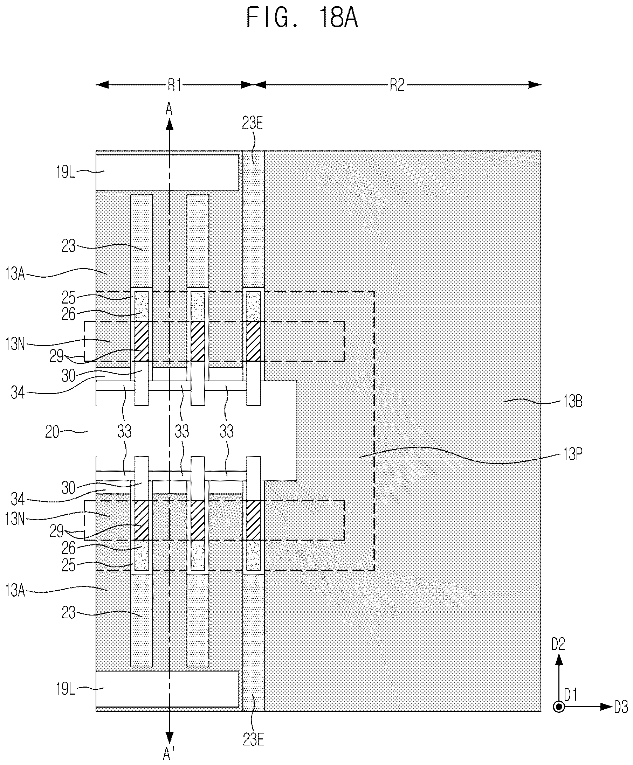

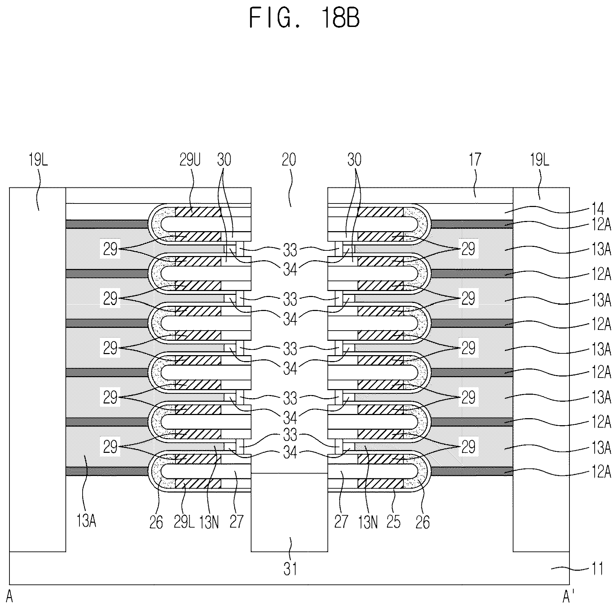

FIG. 18A is a plan view illustrating the structure at the narrow nano sheet level for describing a method for forming first contact nodes 33. FIG. 18B is a cross-sectional view of the structure taken along line A-A' illustrated in FIG. 18A.

Referring to FIGS. 18A and 18B, the first contact nodes 33 may be formed to fill the nano sheet level recesses 32. Forming the first contact nodes 33 may include depositing a conductive material filling the nano sheet level recesses 32 and performing an etch-back process on the conductive material. The first contact nodes 33 may each include a semiconductive material. The first contact nodes 33 may each include doped polysilicon, and the doped polysilicon may include N-type dopants. Each of the first contact nodes 33 may fill the inner spaces of the second spacers 30. The first contact nodes 33 and the second spacers 30 may not be self-aligned in the first direction D1. In some embodiments, the first contact nodes 33 may be formed by selective epitaxial growth (SEG).

First doped regions 34 may be formed within one side of the narrow nano sheets 13N. A heat treatment process may be performed to form the first doped regions 34, and thus dopants may be diffused from the first contact nodes 33.

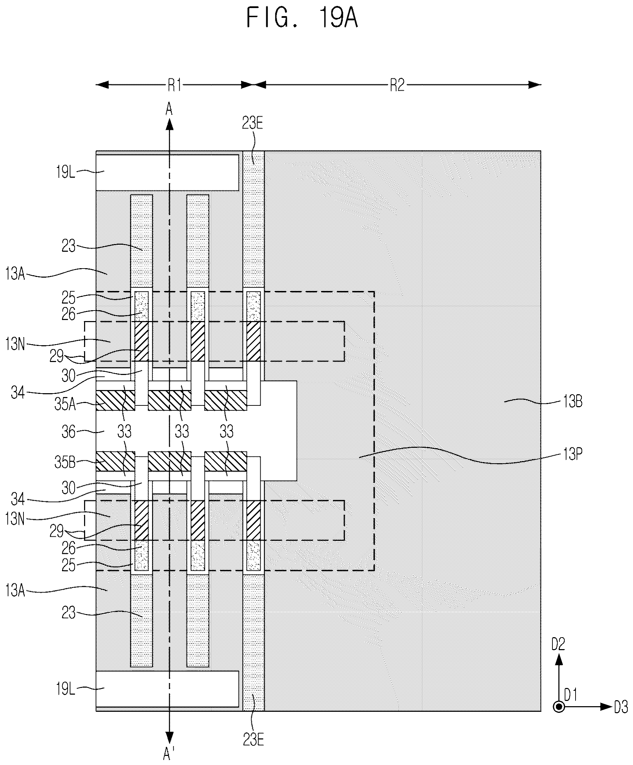

FIG. 19A is a plan view illustrating the structure at a nano sheet level for describing a method for forming first and second vertical conductive lines 35A and 35B.

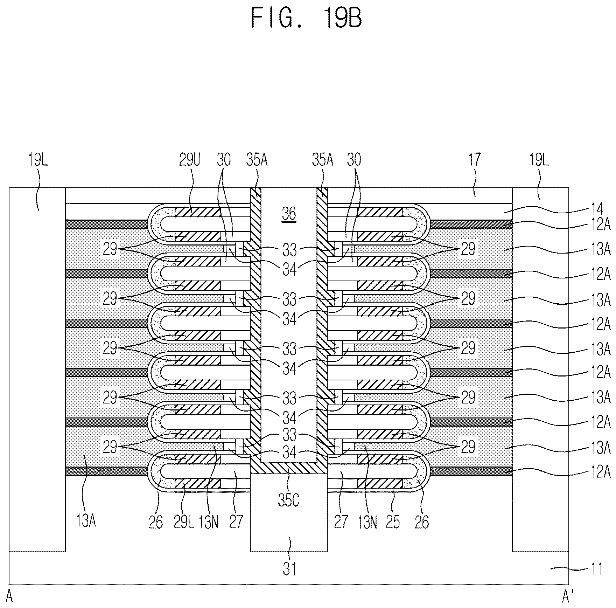

FIG. 19B is a cross-sectional view of the structure taken along line A-A' illustrated in FIG. 19A.

Referring to FIGS. 19A and 19B, the first and second vertical conductive lines 35A and 35B may be formed on the first contact nodes 33. Before the first and second vertical conductive lines 35A and 35B are formed, ohmic contact layers (refer to reference symbol "BLO" of FIGS. 1B and 2A) may be formed on the first contact nodes 33. The ohmic contact layers may each include metal silicide such as titanium silicide or molybdenum silicide.

Bottom portions 35C of the first and second vertical conductive lines 35A and 35B may be merged with each other.

The first and second vertical conductive lines 35A and 35B may be coupled in common to the narrow nano sheets 13N disposed in the first direction D1.

Subsequently, a vertical isolation layer 36 may be formed to fill the first linear opening 20 on the first and second vertical conductive lines 35A and 35B. The vertical isolation layer 36 may vertically extend in the first direction D1 and horizontally in the third direction D3. The first and second vertical conductive lines 35A and 35B disposed adjacent to each other in the third direction D3 may be isolated by the vertical isolation layer 36. The vertical isolation layer 36 may include, a dielectric material. The vertical isolation layer 36 may include, for example, silicon oxide, silicon nitride, an air gap, or a combination thereof.

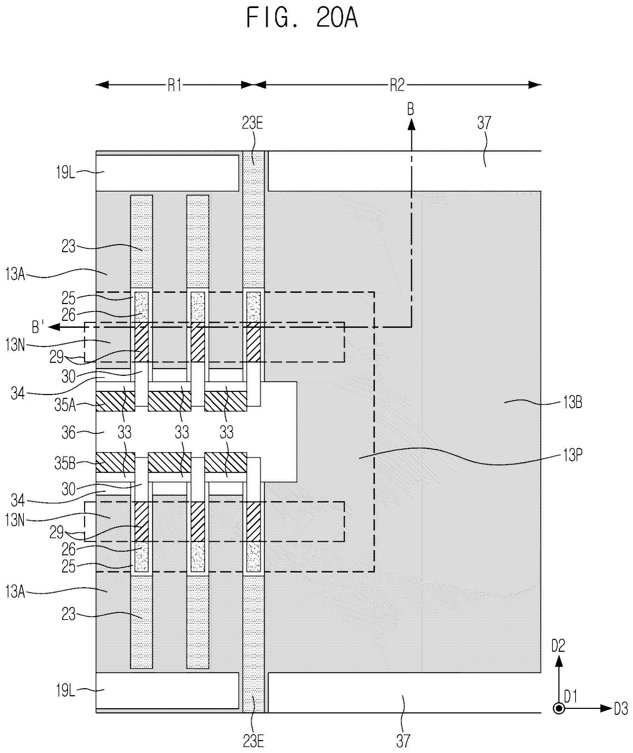

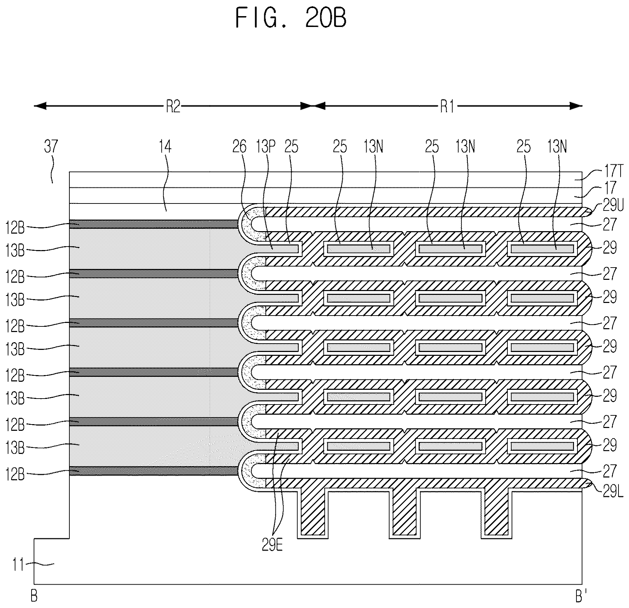

FIG. 20A is a plan view illustrating the structure at the nano sheet level for describing a method for forming pad isolation openings 37. FIG. 20B is a cross-sectional view of the structure taken along line B-B' illustrated in FIG. 20A.

Referring to FIGS. 20A and 20B, the pad-side first mold layers 12B and the pad-side second mold layers 13B may be etched in the second region R2 to form a plurality of pad isolation openings 37. The pad isolation openings 37 may extend horizontally in the third direction D3 and vertically in the first direction D1. A third hard mask layer 17T may be used as an etch barrier to form the plurality of pad isolation openings 37.

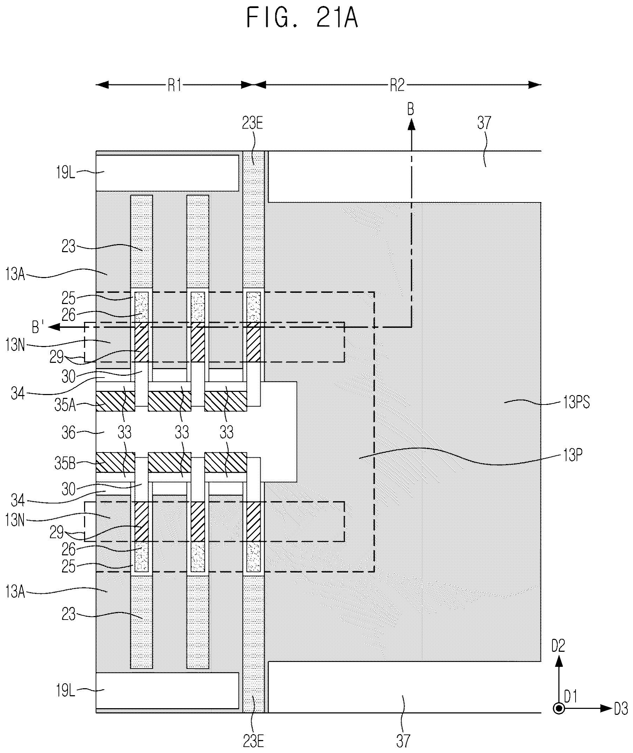

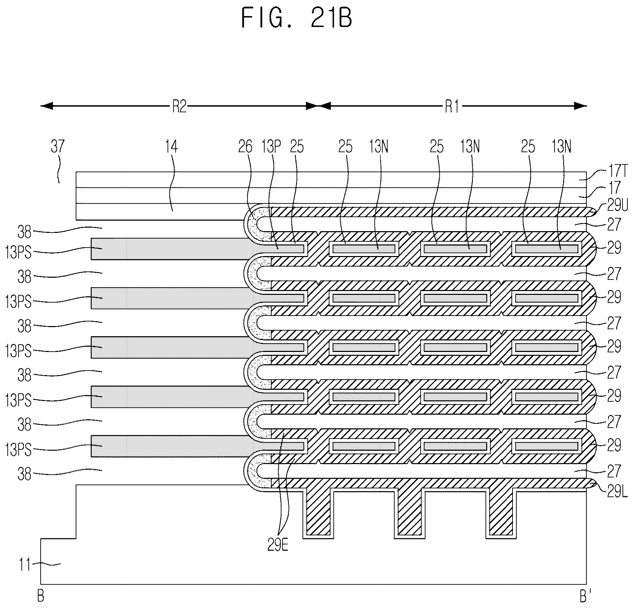

FIG. 21A is a plan view illustrating the structure at the nano sheet level for describing a method for forming pad-side sheets 13PS. FIG. 21B is a cross-sectional view of the structure taken along line B-B' illustrated in FIG. 21A.

Referring to FIGS. 21A and 21B, the pad-side first mold layers 12B and the pad-side second mold layers 13B may be sequentially recessed to form the pad-side sheets 13PS in the second region R2. The pad-side first mold layers 12B may be removed entirely, whereas upper and lower surfaces of the pad-side second mold layers 13B may be recessed.

Each of inter-pad recesses 38 may be formed between the pad-side sheets 13PS. The upper and lower surfaces of the narrow nano sheets 13N may each include a flat surface.

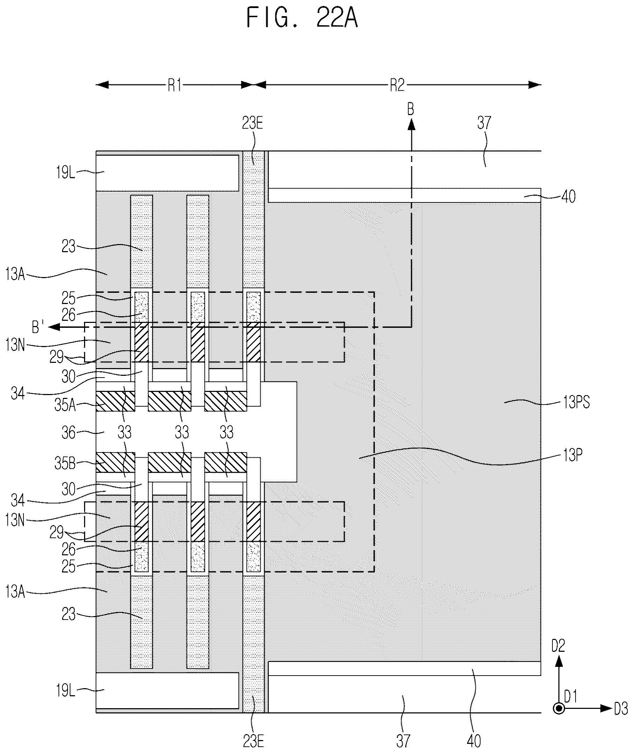

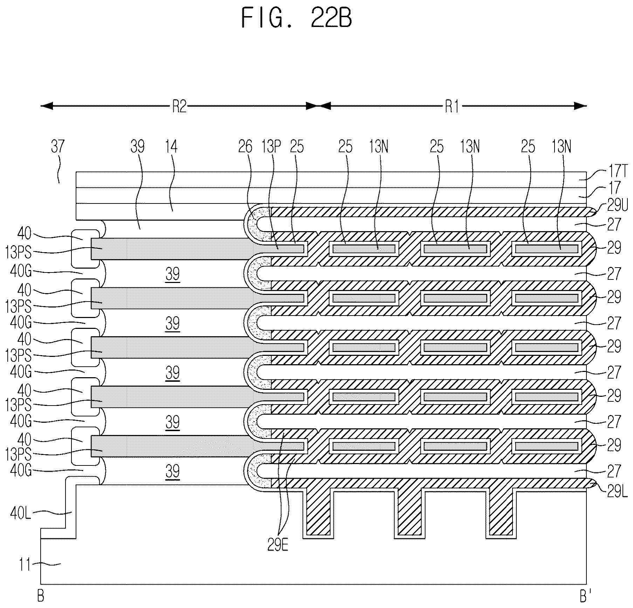

FIG. 22A is a plan view illustrating the structure at the nano sheet level for describing a method for forming pad-side sacrificial layers 39. FIG. 22B is a cross-sectional view of the structure taken along line B-B' illustrated in FIG. 22A.

Referring to FIGS. 22A and 22B, the pad-side sacrificial layers 39 may be formed to fill the inter-pad recesses 38 in the second region R2. The pad-side sacrificial layers 39 may each include, for example, silicon oxide, silicon nitride, or a combination thereof.

Deposition and etch-back processes of a sacrificial material may be performed to form the pad-side sacrificial layers 39. After the pad-side sacrificial layers 39 are formed, outer edges of the pad-side sheets 13PS may be exposed.

Subsequently, a growth layer 40 may be selectively formed on the outer edges of each of the pad-side sheets 13PS. The growth layers 40 may be formed by the selective epitaxial growth (SEG). The growth layers 40 may include silicon epitaxial layers. A vertical height of each of the growth layers 40 may be greater than a vertical height of each of the pad-side sheets 13PS. Accordingly, a strip path 40G may be defined in a narrow space between the growth layers 40.

While the growth layers 40 are formed, a dummy growth layer 40L may be formed on the surface of the substrate 11.

As described above, the pad-side sacrificial layers 39 and the growth layers 40 may be formed in the second region R2.

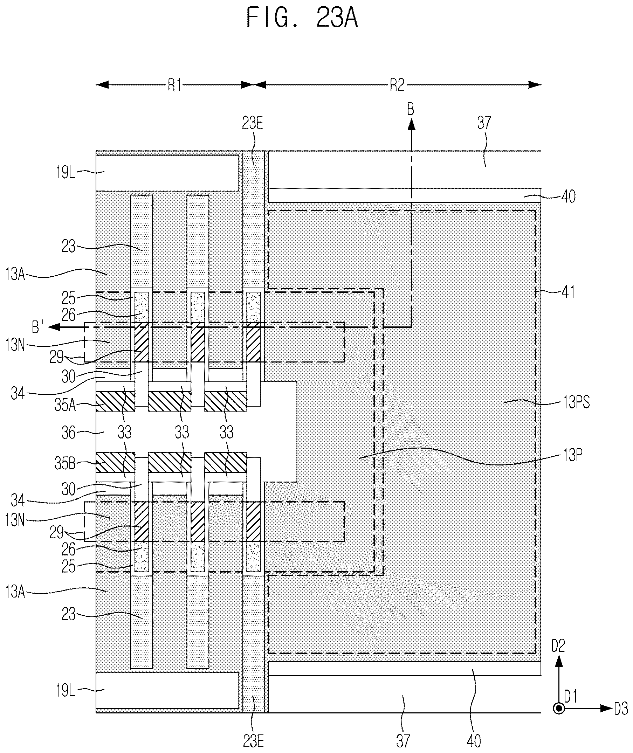

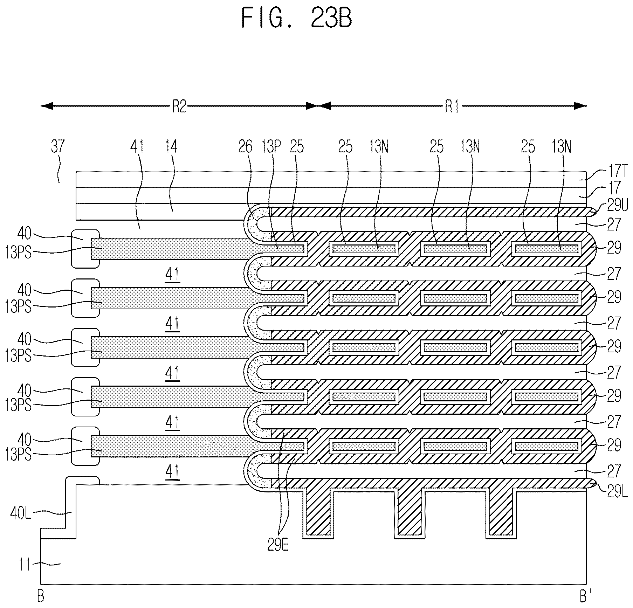

FIG. 23A is a plan view illustrating the structure at the nano sheet level for describing a method for forming pad-side initial air gaps 41. FIG. 23B is a cross-sectional view of the structure taken along line B-B' illustrated in FIG. 23A.

Referring to FIGS. 23A and 23B, the pad-side sacrificial layers 39 may be removed through the strip paths 40G to form the pad-side initial air gaps 41. Each of the pad-side initial air gaps 41 may be defined between the pad-side sheets 13PS. An entrance of each of the pad-side initial air gaps 41 may be narrower than an internal space.

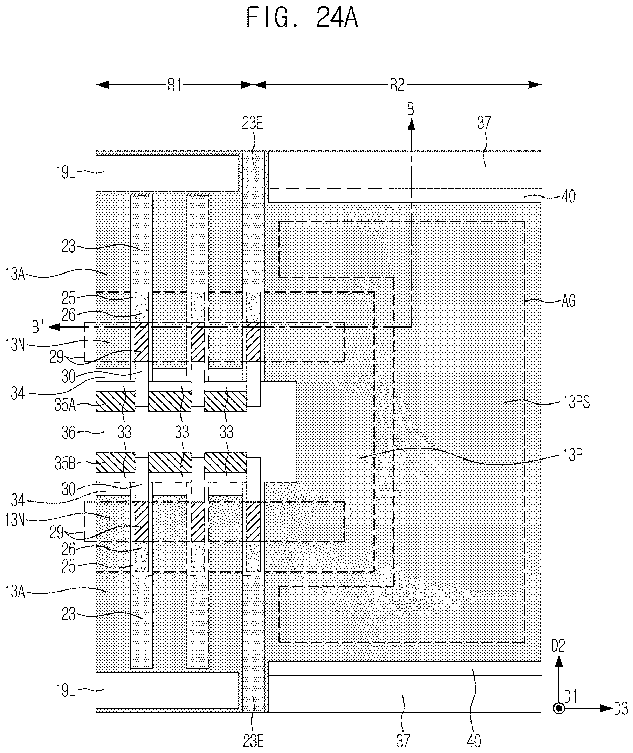

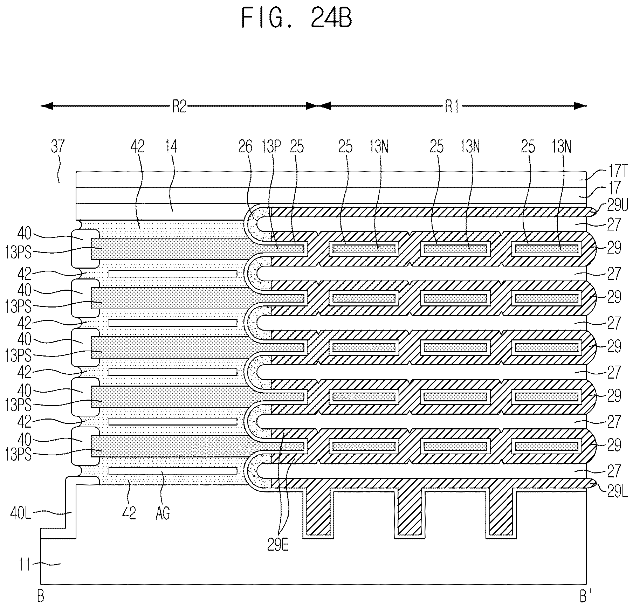

FIG. 24A is a plan view illustrating the structure at the nano sheet level for describing a method for forming inter-pad dielectric layers 42. FIG. 24B is a cross-sectional view of the structure taken along line B-B' illustrated in FIG. 24A.

Referring to FIGS. 24A and 24B, the inter-pad dielectric layers 42 may be formed by partially filling the pad-side initial air gaps 41 so that the inter-pad dielectric layers 42 may each include an embedded air gap AG. The inter-pad dielectric layers 42 may each include for example, silicon oxide, silicon carbon oxide, or a combination thereof. The embedded air gaps AG may be formed while the inter-pad dielectric layers 42 are deposited. That is, because each of the pad-side initial air gaps 41 of FIGS. 23A and 23B have a narrow line width of the entrance compared to the internal space, the embedded air gaps AG may be simultaneously formed while the inter-pad dielectric layers 42 are formed. Each of the inter-pad dielectric layers 42 including the embedded air gaps AG may be disposed between the pad-side sheets 13PS. The inter-pad dielectric layer 42 and the embedded air gap AG may be referred to as an "inter-pad isolation layer".

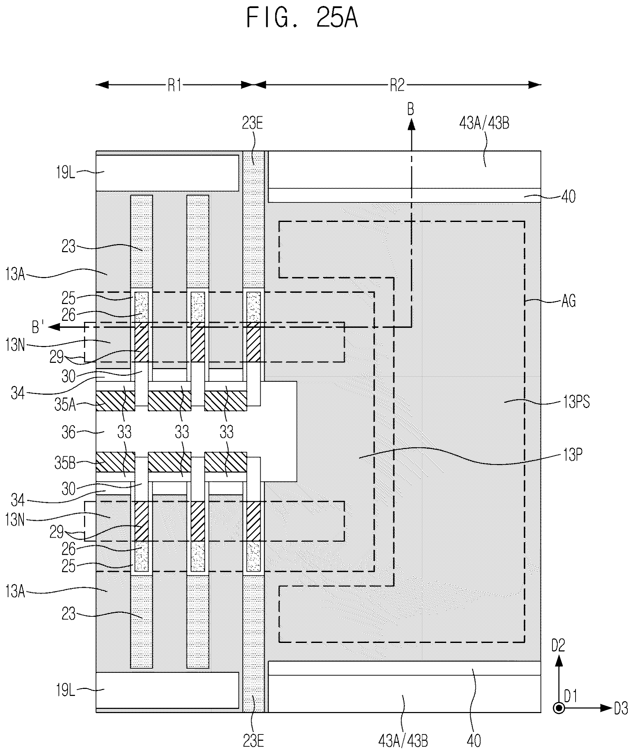

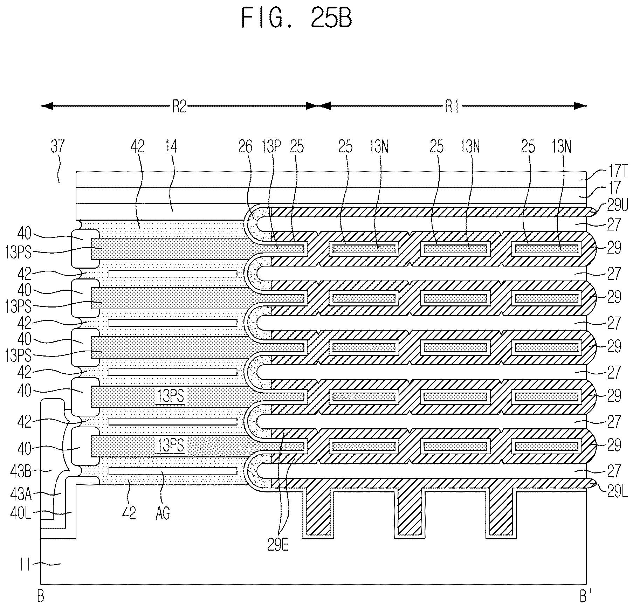

FIG. 25A is a plan view illustrating the structure at the nano sheet level for describing a method for forming first and second pad supporter layers 43A and 43B. FIG. 25B is a cross-sectional view of the structure taken along line B-B' illustrated in FIG. 25A.

Referring to FIGS. 25A and 25B, the first and second pad supporter layers 43A and 43B may be formed by filling bottom portions of the pad isolation openings 37 with a dielectric material. Portions of the growth layers 40 may be exposed by the first and second pad supporter layers 43A and 43B.

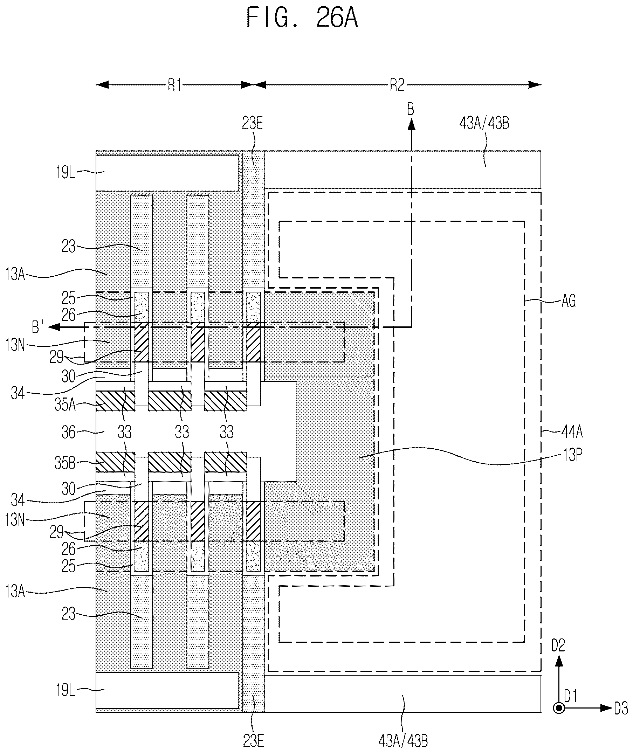

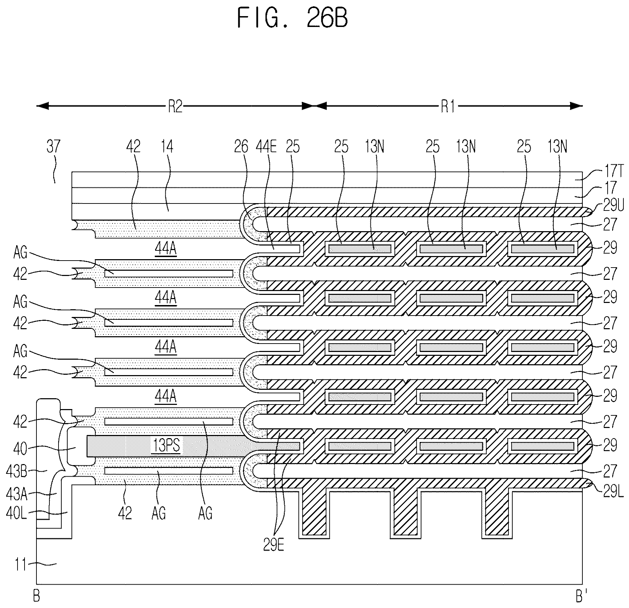

FIG. 26A is a plan view illustrating the structure at the nano sheet level for describing a method for forming initial pad-shaped openings 44A. FIG. 26B is a cross-sectional view of the structure taken along line B-B' illustrated in FIG. 26A.

Referring to FIGS. 26A and 26B, the pad-side sheets 13PS may be selectively removed to form the initial pad-shaped openings 44A between the inter-pad dielectric layers 42. The initial pad-shaped openings 44A may include inner edges 44E. The inner edges 44E may expose the nano sheet dielectric layer 25. The inner edges 44E of the initial pad-shaped openings 44A may be disposed in the inner spaces of the edge portions 29E of the horizontal conductive lines 29.

The pad-side sheets 13PS protected by the first and second pad supporter layers 43A and 43B may be dummy sheets.

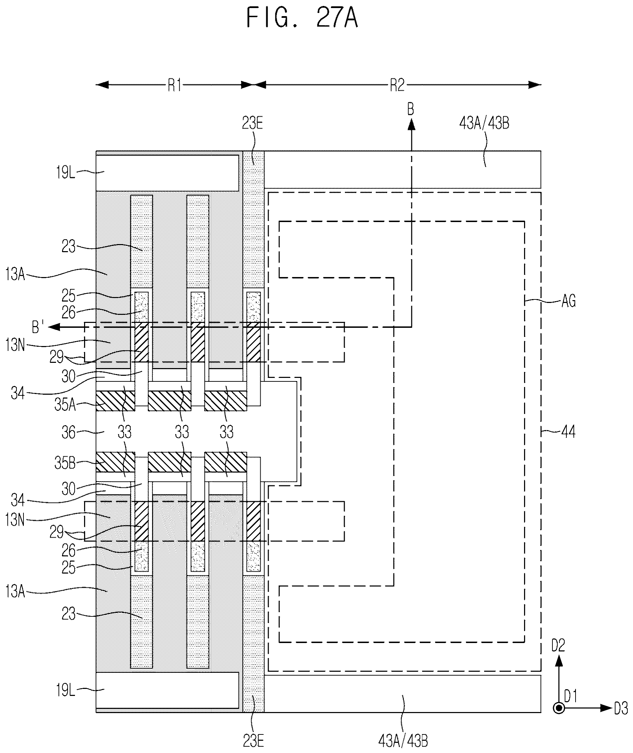

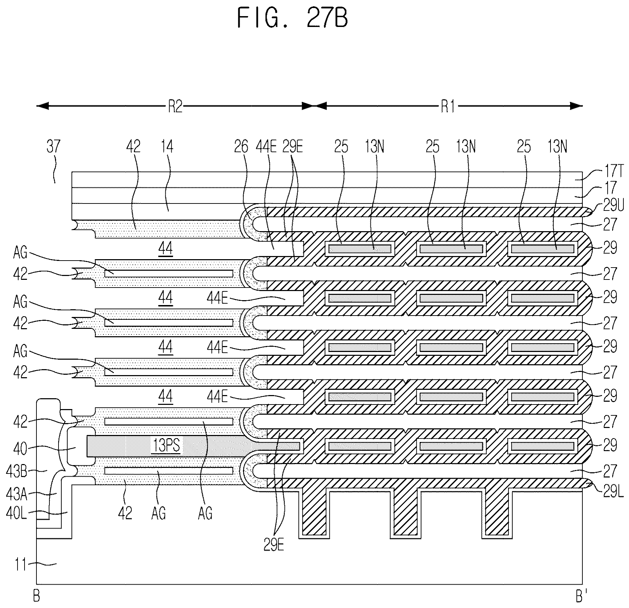

FIG. 27A is a plan view illustrating the structure at the nano sheet level for describing a method for forming pad-shaped openings 44. FIG. 27B is a cross-sectional view of the structure taken along line B-B' illustrated in FIG. 27A.

Referring to FIGS. 27A and 27B, the initial pad-shaped openings 44A may be expanded to form the pad-shaped openings 44. That is, the nano sheet dielectric layer 25 may be cut through the inner edges 44E of the initial pad-shaped openings 44A. Accordingly, the edge portions 29E of the horizontal conductive lines 29 and the first spacers 26 may be exposed.

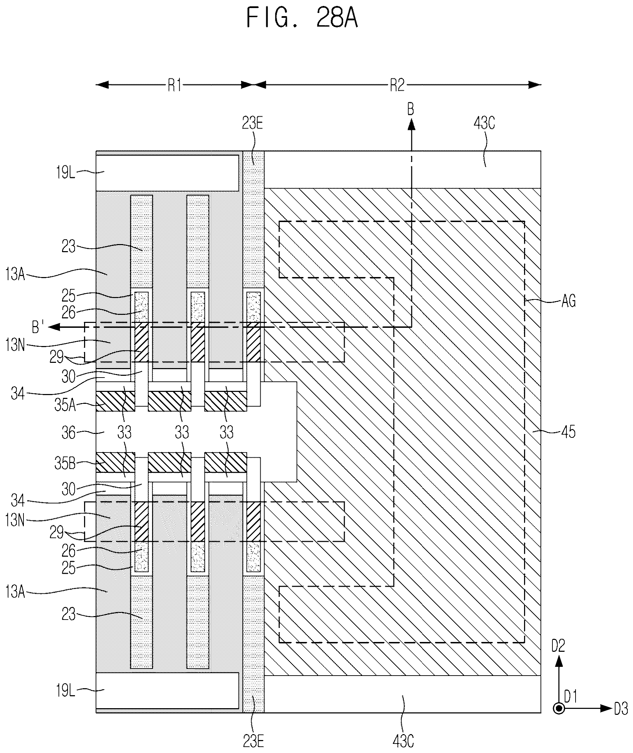

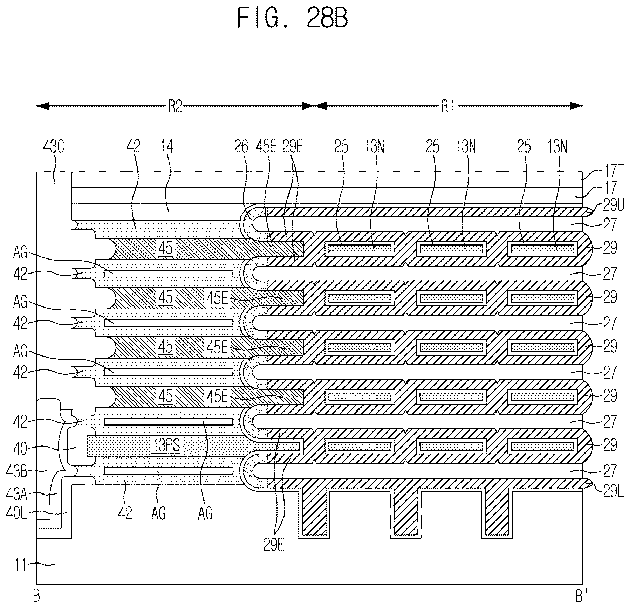

FIG. 28A is a plan view illustrating the structure at the nano sheet level for describing a method for forming pads 45. FIG. 28B is a cross-sectional view of the structure taken along line B-B' illustrated in FIG. 28A.

Referring to FIGS. 28A and 28B, the pads 45 may be formed to fill the pad-shaped openings 44 by deposition and etch processes of a pad material. The pads 45 may be electrically coupled to the horizontal conductive lines 29. The pads 45 and the horizontal conductive lines 29 may be made of the same material or different materials. For example, the pads 45 may each include titanium nitride, tungsten, or a combination thereof. The pads 45 may include convex-shaped inner edges 45E, and the inner edges 45E of the pads 45 may be coupled to the edge portions 29E of the horizontal conductive lines 29.

After the pads 45 are formed, a third pad support layer 43C may be formed. The third pad support layer 43C may include a dielectric material. A horizontal length of each of the air gaps AG in the second and third directions D2 and D3 may be formed to be less than a horizontal length of each of the pads 45.

As described above, each of the embedded air gaps AG may be disposed between the pads 45, which makes it possible to reduce parasitic capacitance between the pads 45 that are vertically stacked. Consequently, parasitic capacitance between the horizontal conductive lines 29 may also be reduced.

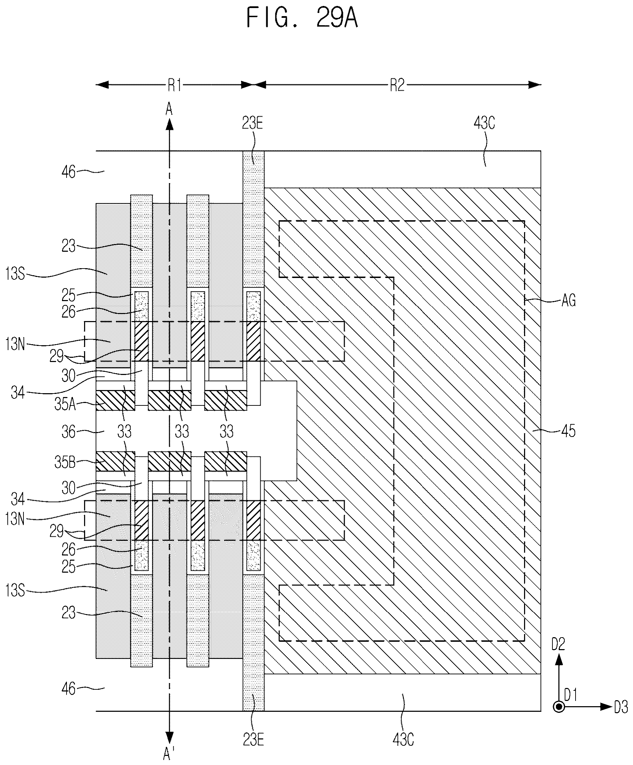

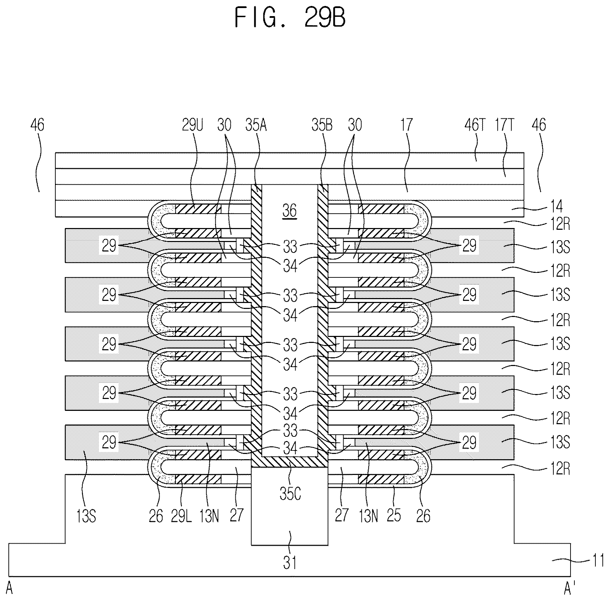

FIG. 29A is a plan view illustrating the structure at the nano sheet level for describing a method for forming second linear openings 46. FIG. 29B is a cross-sectional view of the structure taken along line A-A' illustrated in FIG. 29A.

Referring to FIGS. 29A and 29B, the second linear sacrificial layer 19L may be removed using a fourth hard mask layer 46T as a barrier to form the second linear openings 46. The second linear openings 46 may be formed in the first region R1.

After the second linear openings 46 are formed, the first mold layers 12A may be selectively recessed through the second linear openings 46. To selectively recess the first mold layers 12A, a difference in etch selectivity between the first mold layers 12A and the original body portions 13A may be used. The first mold layers 12A may be removed using a wet etch process or a dry etch process. For example, when the first mold layers 12A include silicon germanium layers and the original body portions 13A include monocrystalline silicon layers, the silicon germanium layers may be etched using an etchant or etch gas having a selectivity with respect to the monocrystalline silicon layers.

Subsequently, the original body portions 13A may be recessed. To recess the original body portions 13A, the wet etch process or the dry etch process may be used. Vertical thicknesses of the original body portions 13A may be reduced, as indicated by reference numeral "13S". Hereinafter, the original body portions having the reduced vertical thicknesses are referred to as "recessed body portions 13S".

Each of inter-body recesses 12R may be formed between the recessed body portions 13S that are vertically disposed.

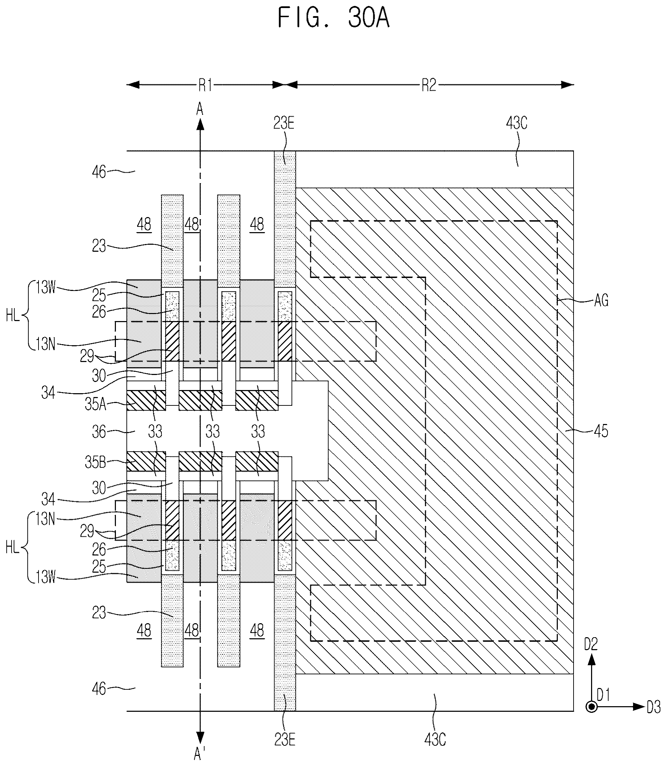

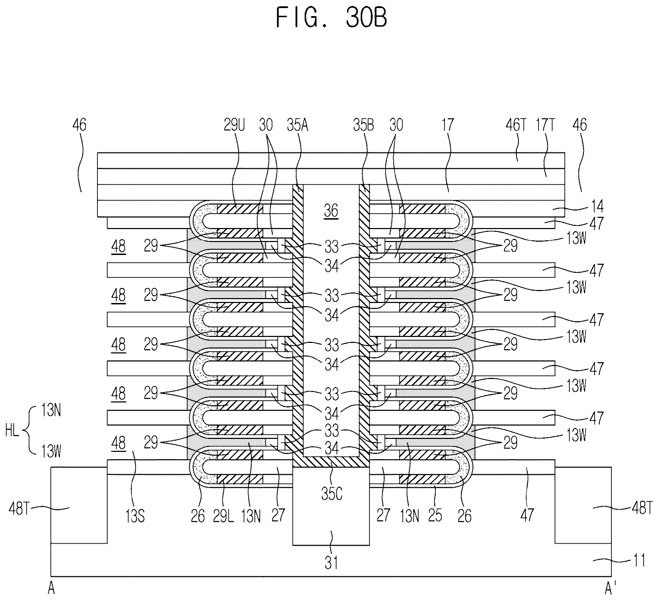

FIG. 30A is a plan view illustrating the structure at the narrow nano sheet level for describing a method for forming nano sheets HL. FIG. 30B is a cross-sectional view of the structure taken along line A-A' illustrated in FIG. 30A.

Referring to FIGS. 30A and 30B, third inter-cell dielectric layers 47 may be formed to fill the inter-body recesses 12R. The third inter-cell dielectric layers 47 may each include, for example, silicon oxide.

After the third inter-cell dielectric layers 47 are formed, second bottom passivation layers 48T may be formed on bottom portions of the second linear openings 46. The second bottom passivation layers 48T may each include a material having an etch selectivity with respect to the substrate 11. The second bottom passivation layers 48T may each include a dielectric material. The second bottom passivation layers 48T may each include, for example, silicon oxide, silicon nitride, silicon carbon oxide, or a combination thereof.

After the second bottom passivation layers 48T are formed, storage openings 48 may be formed by horizontal recessing of the recessed body portions 13S. The storage openings 48 may be referred to as "capacitor openings". The nano sheets HL may be formed by the horizontal recessing of the recessed body portions 13S. Each of the nano sheets HL may include the narrow nano sheet 13N and wide nano sheet 13E. The narrow nano sheet 13N may include a first doped region 34. The wide nano sheet 13E of the nano sheet HL may refer to the recessed body portion 13S remaining after the recessing. An average vertical height of the wide nano sheets 13E of the nano sheets HL in the first direction D1 may be greater than an average vertical height of the narrow nano sheets 13N. A thickness of the wide nano sheet 13E of the nano sheet HL may gradually increase in the second direction D2. A horizontal length of the wide nano sheet 13E in the second direction D2 may be less than a horizontal length of the narrow nano sheet 13N. The wide nano sheet 13E of the nano sheet HL may have a fan-like shape. The wide nano sheet 13E may be referred to as a "fan-shaped sheet", and the narrow nano sheet 13N may be referred to as a "flat plate-shaped sheet".

To form the nano sheets HL each including the wide nano sheet 13E, the recessed body portions 13S may be isotropically or anisotropically etched. One side of the wide nano sheet 13E, i.e., the side exposed by each of the storage openings 48, may have a flat shape. The one side of the wide nano sheet 13E may have various shapes.

The one side of the wide nano sheet 13E may have various shapes. For example, the one side of the wide nano sheet 13E may have a rounded concave shape, a rounded convex shape, an angled concave shape, or an angled convex shape.

The second bottom passivation layers 48T and a lowermost third inter-cell dielectric layer 47 may prevent loss of the substrate 11 during the recessing process of the recessed body portions 13S.

Each of the storage openings 48 may be disposed between the third inter-cell dielectric layers 47 in the first direction D1.

In some embodiments, the horizontal recessing of the recessed body portions 13S for forming the wide nano sheets 13E may stop at a boundary area between the narrow nano sheet 13P and the wide nano sheet 13E.

The first spacer 26 may surround the wide nano sheets 13W at the same horizontal level, which are disposed in third direction D3. The second spacer 30 may surround the narrow nano sheets 13N at the same horizontal level, which are disposed in the third direction D3.

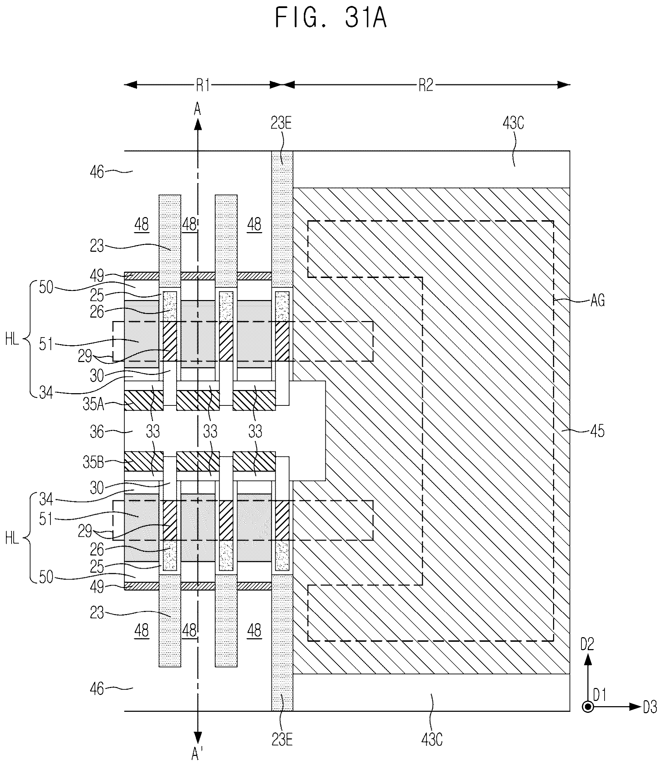

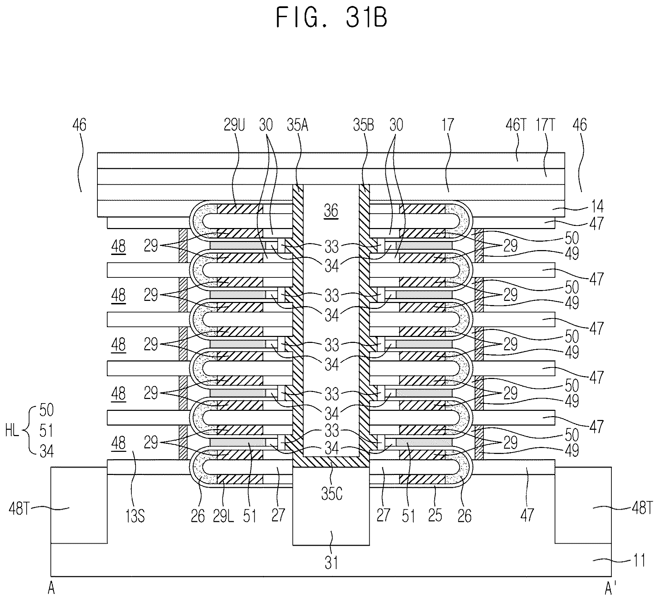

FIG. 31A is a plan view illustrating the structure at the narrow nano sheet level for describing a method for forming the nano sheets HL. FIG. 31B is a cross-sectional view illustrating the structure taken along line A-A' illustrated in FIG. 31A.

Referring to FIGS. 31A and 31B, a pre-cleaning process may be performed on the surfaces of the wide nano sheets 13E.

The second contact nodes 49 may be formed on the wide nano sheets 13E, for example, by a process including selective epitaxial growth (SEG). For example, a semiconductor material may be grown from the side surfaces of the wide nano sheets 13E through selective epitaxial growth (SEG). The second contact nodes 49 may each include SEG Si. Because the wide nano sheets 13E may each include monocrystalline silicon, a silicon layer may be epitaxially grown along crystal surfaces of the side surfaces of the wide nano sheets 13E.

The second contact nodes 49 may each include a dopant. When the silicon layer is grown using the selective epitaxial growth (SEG), dopants may be doped in situ. Accordingly, the second contact nodes 49 may each be a doped epitaxial layer. The second contact nodes 49 may each include an N-type dopant as the dopant. The N-type dopant may include phosphorus, arsenic, antimony, or a combination thereof. The second contact nodes 49 may each include a phosphorus-doped silicon epitaxial layer formed by the selective epitaxial growth (SEG), i.e., a doped SEG SiP. In some embodiments, the second contact nodes 49 may be formed through deposition and etch-back processes of doped polysilicon.

Each of the second contact nodes 49 may be disposed between the third inter-cell dielectric layers 47 that are vertically stacked. The second contact nodes 49 may correspond to the second contact node SNC illustrated in FIG. 4B.

Second doped regions 50 may be formed in the wide nano sheets 13E. A heat treatment process may be performed to form the second doped regions 50, and thus dopants may be diffused from the second contact nodes 49.

A channel 51 may be defined between the first doped region 34 and the second doped region 50. A horizontal arrangement of the first doped region 34, the channel 51 and the second doped region 50 may constitute the nano sheet HL. Hence, each of the nano sheets HL may include the first doped region 34, the second doped region 50, and the channel 51 which is disposed between the first and second doped regions 34 and 50. The first doped region 34 and the channel 51 may be formed in the narrow nano sheet 13N. The second doped region 50 may be formed in the wide nano sheet 13E. A portion of each of the second doped regions 50 may extend into the narrow nano sheets 13N. One side of each of the second doped regions 50 of the nano sheets HL may be coupled to the channel 51. The other side of each of the second doped regions 50 of the nano sheets HL may be coupled to the second contact nodes 49.

The first spacer 26 may surround the second doped regions 50 at the same horizontal level, which are disposed in the third direction D3. The second spacer 30 may surround the first doped regions 34 at the same horizontal level, which are disposed in the third direction D3. The horizontal conductive line 29 may surround the channels 51 at the same horizontal level, which are disposed in the third direction D3.

In some embodiments, an ohmic contact layer including metal silicide may be further formed after the second contact nodes 49 are formed.

As described above, the nano sheets HL may be formed by subsequent selective recessing processes on the second mold layers 13 of the mold stack SB, and each of the nano sheets HL may include the narrow nano sheet 13N and the wide nano sheet 13W. The first doped regions 34 and the channels 51 may be formed in the narrow nano sheets 13N, and the second doped regions 50 may be formed in the wide nano sheets 13W.

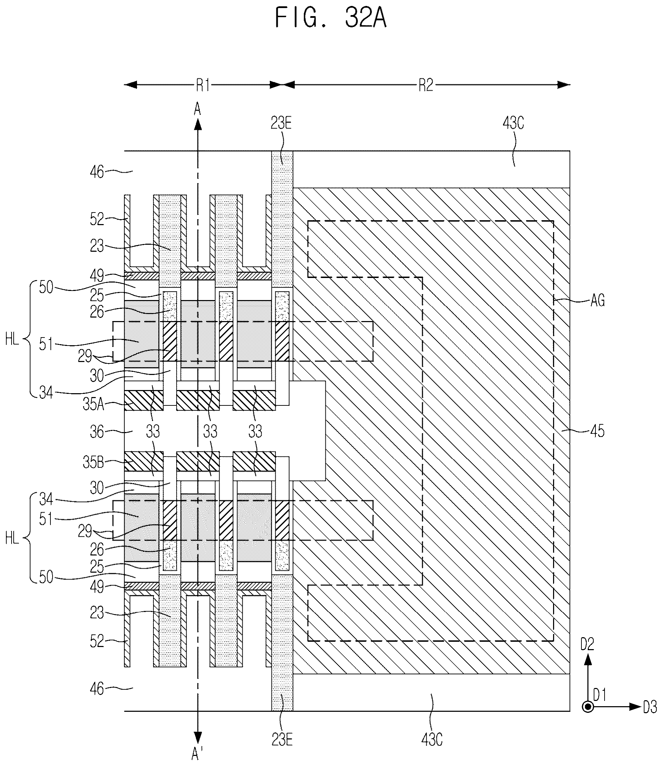

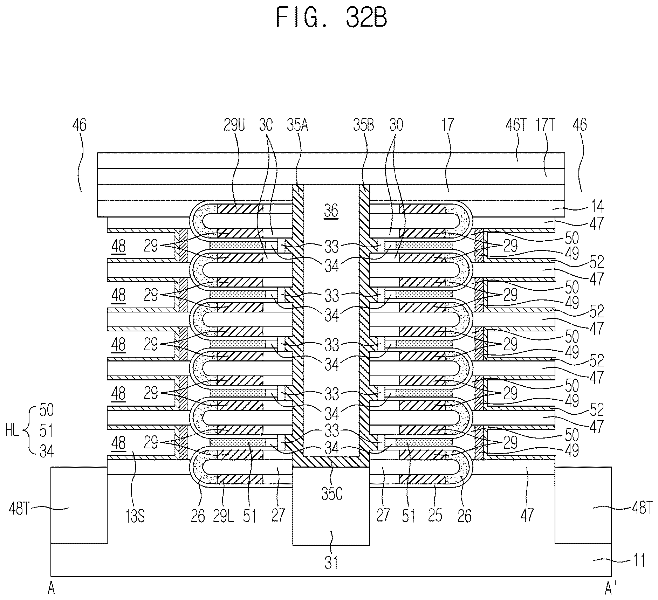

FIG. 32A is a plan view illustrating the structure at the narrow nano sheet level for describing a method for forming first electrodes 52. FIG. 32B is a cross-sectional view illustrating the structure taken along line A-A' illustrated in FIG. 32A.

Referring to FIGS. 32A and 32B, a plurality of the first electrodes 52 of a data storage element may be formed, each first electrode 52 is disposed on a corresponding one of the second contact nodes 49. The first inter-cell dielectric layers 23 may be disposed between the first electrodes 52 and the second contact nodes 49 as shown in FIG. 32A. The first electrodes 52 may each have a horizontally-oriented cylindrical shape, or rectangular U shape with the base of the U shape positioned on the second contact node 49. Each of the first electrodes 52 may be disposed in a different one of the storage openings 48. The first electrodes 52 disposed adjacent to each other in the second direction D2 may be spaced apart from each other by the second linear openings 46 as shown in FIG. 32B. The first electrodes 52 disposed adjacent to each other in the first direction D1 may be spaced apart from each other by the third inter-cell dielectric layers 47. Forming the first electrodes 52 may include depositing a metal material, gap-filling a sacrificial material, and isolating the metal material in a vertical/horizontal direction. The sacrificial material may include, for example, oxide or polysilicon.

Each of the first electrodes 52 may include an inner space and a plurality of outer surfaces. The inner space of the first electrode 52 may include a plurality of inner surfaces. The outer surfaces of the first electrode 52 may include a vertical outer surface and a plurality of horizontal outer surfaces. The vertical outer surface of the first electrode 52 may vertically extend in the first direction D1. The horizontal outer surfaces of the first electrode 52 may horizontally extend in the second direction D2 or the third direction D3. The inner space of the first electrode 52 may be a three-dimensional space. The first electrode 52 may have a cylindrical shape.

Among the outer surfaces of the first electrode 52, the vertical outer surface may be electrically coupled to the nano sheet HL and the second contact node 49.

The first electrode 52 may include metal, noble metal, metal nitride, conductive metal oxide, conductive noble metal oxide, metal carbide, metal silicide, or a combination thereof. For example, the first electrode 52 may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, or a combination thereof.

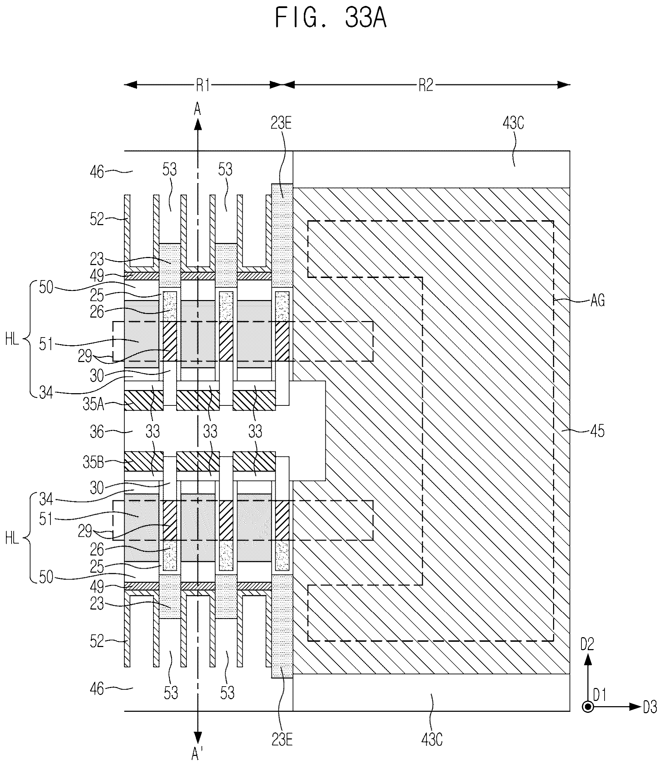

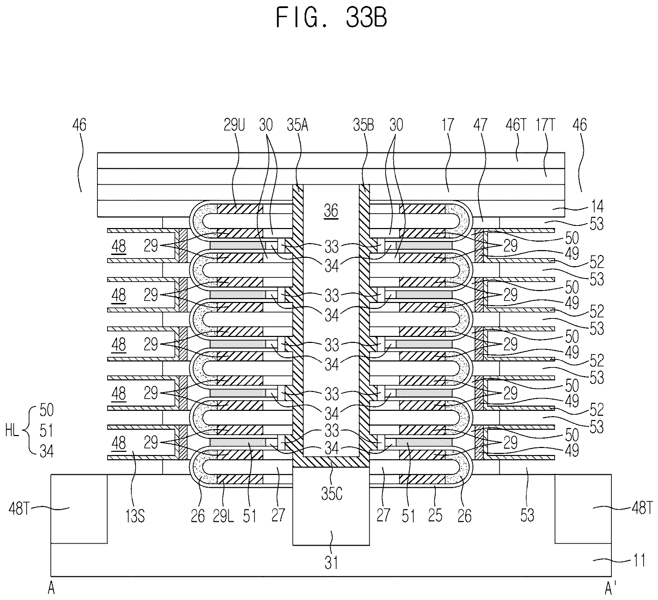

FIG. 33A is a plan view illustrating the structure at the narrow nano sheet level for describing a method for partially recessing the third inter-cell dielectric layers 47. FIG. 33B is a cross-sectional view of the structure taken along line A-A' illustrated in FIG. 33A.

Referring to FIGS. 33A and 33B, portions of the first and third inter-cell dielectric layers 23 and 47 may be horizontally recessed as indicated by reference numeral "53". Accordingly, the outer walls of the first electrodes 52 may be partially exposed. The first electrodes 52 may each have a semi-cylindrical shape. Horizontal recess depths of the third inter-cell dielectric layers 47 may be depths that do not expose the second contact nodes 49. The semi-cylindrical shape of each of the first electrodes 52 may include cylindrical inner surfaces and semi-cylindrical outer surfaces.

While the first inter-cell dielectric layers 23 and the third inter-cell dielectric layers 47 are recessed, portions of the edge first inter-cell dielectric layers 23E may be recessed. While the edge first inter-cell dielectric layers 23E are recessed, the pads 45 may not be exposed by the third pad support layer 43C.

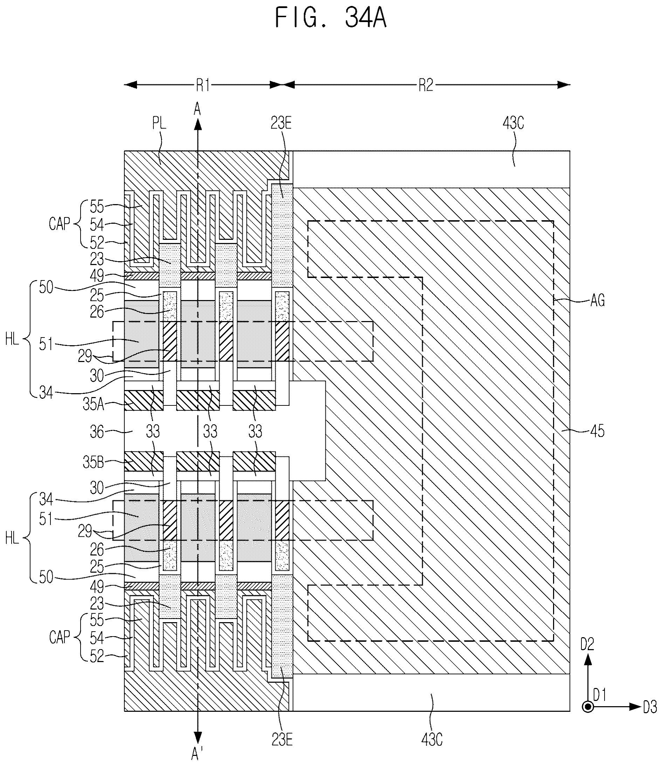

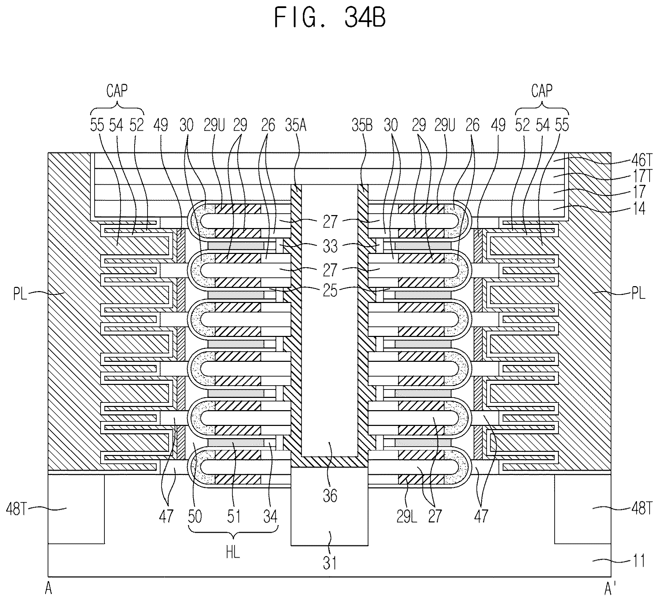

FIG. 34A is a plan view illustrating the structure at the narrow nano sheet level for describing a method for forming a second electrode 55. FIG. 34B is a cross-sectional view of the structure taken along line A-A' illustrated in FIG. 34A.

Referring to FIGS. 34A and 34B, a dielectric layer 54 and the second electrode 55 may be sequentially formed on the first electrodes 52. The first electrode 52, the dielectric layer 54 and the second electrode 55 may constitute the data storage element CAP. The second electrodes 55 of the data storage elements CAP may be merged with one another and form a common plate PL.

The dielectric layer 54 and the second electrode 55 may be disposed on the cylindrical inner surfaces of the first electrode 52. A portion of the dielectric layer 54 and a portion of the second electrode 55 may extend to be disposed on the semi-cylindrical outer surfaces of the first electrode 52. The second electrode 55 may vertically extend in the first direction D1.

The dielectric layer 54 may be referred to as a "capacitor dielectric layer" or a "memory layer". The dielectric layer 54 may include, for example, silicon oxide, silicon nitride, a high-k material, a ferroelectric material, an antiferroelectric material, a perovskite material, or a combination thereof. The dielectric layer 54 may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅), or strontium titanium oxide (SrTiO₃). The dielectric layer 54 may include a ZA (ZrO₂/Al₂O₃) stack, a ZAZ (ZrO₂/Al₂O₃/ZrO₂) stack, a ZAZA (ZrO₂/Al₂O₃/ZrO₂/Al₂O₃) stack, a ZAZAZ (ZrO₂/Al₂O₃/ZrO₂/Al₂O₃/ZrO₂) stack, a HA (HfO₂/Al₂O₃) stack, a HAH (HfO₂/Al₂O₃/HfO₂) stack, a HAHA (HfO₂/Al₂O₃/HfO₂/Al₂O₃) stack, a HAHAH (HfO₂/Al₂O₃/HfO₂/Al₂O₃/HfO₂) stack, a HZAZH (HfO₂/ZrO₂/Al₂O₃/ZrO₂/HfO₂) stack, a ZHZAZHZ (ZrO₂/HfO₂/ZrO₂/Al₂O₃/ZrO₂/HfO₂/ZrO₂) stack, a HZHZ (HfO₂/ZrO₂/HfO₂/ZrO₂) stack, or an AHZAZHA (Al₂O₃/HfO₂/ZrO₂/Al₂O₃/ZrO₂/HfO₂/Al₂O₃) stack.

The second electrode 55 may include metal, noble metal, metal nitride, conductive metal oxide, conductive noble metal oxide, metal carbide, metal silicide, or a combination thereof. For example, the second electrode 55 may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, or a combination thereof. The second electrode 55 may also include a combination of a metal-based material and a silicon-based material. For example, a titanium nitride, tungsten and polysilicon may be sequentially stacked in the second electrode 55.

In some embodiments, an interface control layer may be further formed between the first electrode 52 and the dielectric layer 54 to alleviate leakage current. The interface control layer may include titanium oxide (TiO₂), tantalum oxide (Ta₂O₅), niobium oxide (Nb₂O₅), niobium nitride (NbN), or a combination thereof. The interface control layer may also be formed between the second electrode 55 and the dielectric layer 54.

In some embodiments, the recessing of the third inter-cell dielectric layers 47 illustrated in FIG. 33B may be omitted. Thereafter, as illustrated in FIG. 34B, the dielectric layer 54 and the second electrode 55 may be formed. Accordingly, the data storage element CAP including the concave-shaped first electrode 52 may be formed.

Referring to FIGS. 5A to 34B, the method for fabricating the semiconductor device may include forming an alternating stack of the pad-side sheets 13PS and the pad-side sacrificial layers 39 over the substrate 11, forming the growth layers 40 on the end terminals of the pad-side sheets 13PS and the strip paths 40G between the growth layers 40, removing the pad-side sacrificial layers 39 through the strip paths 40G between the growth layers 40 to form the initial air gaps 41 between the pad-side sheets 13PS, forming the inter-pad dielectric layers 42 including the air gaps AG while filling the initial air gaps 41, forming the pad-shaped openings 44 between the inter-pad dielectric layers 42 by removing the pad-side sheets 13PS, and forming the pads 45 filling the pad-shaped openings 44. Because the air gaps AG are disposed between the pads 45, parasitic capacitance between the pads 45, which occurs in the second region R2, may be reduced. Consequently, parasitic capacitance between the horizontal conductive lines 29 may be reduced by the air gaps AG. Accordingly, an RC delay may be minimized while the horizontal conductive lines 29 operate.

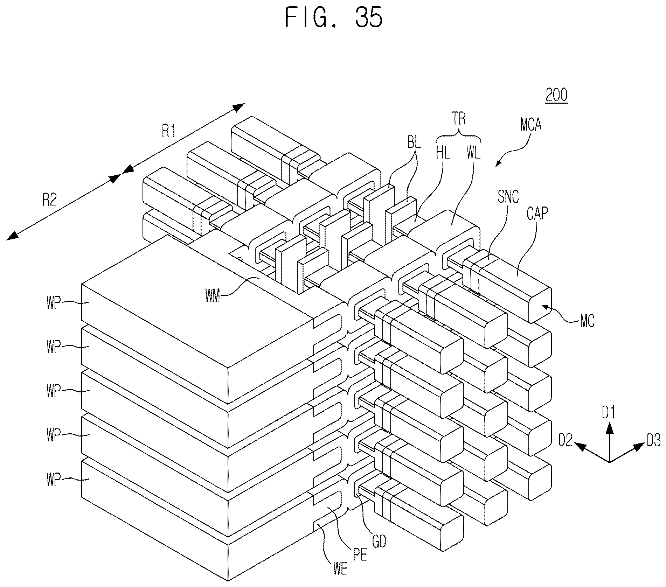

FIG. 35 is a simplified schematic perspective view illustrating a semiconductor device 200 in accordance with an embodiment of the present disclosure. The semiconductor device 200 illustrated in FIG. 35 may be similar to the semiconductor device 100 illustrated in FIG. 4A. Detailed descriptions of overlapping components are provided above with reference to FIG. 4A.

Referring to FIG. 35, the semiconductor device 200 may include a memory cell array MCA. The memory cell array MCA may include a three-dimensional array of memory cells MC. The memory cell array MCA may include a first region R1 and a second region R2. The three-dimensional array of the memory cells MC may be disposed in the first region R1, and the second region R2 may include pads WP each coupled to a different one of second conductive lines WL.

Edge portions of the second conductive lines WL may have a mutually-merged structure (refer to reference symbol "WM"). The semiconductor device 100 illustrated in FIG. 4A may have a structure in which the edge portions of the second conductive lines WL are isolated from each other.

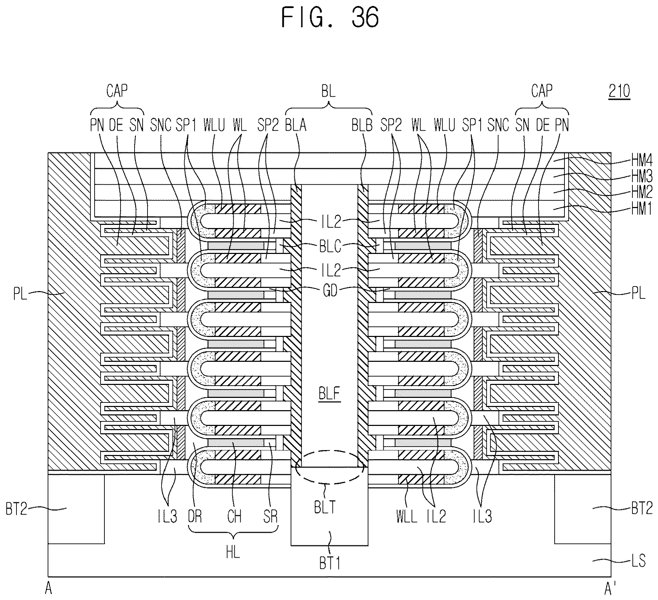

FIG. 36 is a simplified schematic cross-sectional view of a semiconductor device 210 in accordance with an embodiment of the present disclosure. The semiconductor device 210 illustrated in FIG. 36 may be similar to the semiconductor device 100 illustrated in FIG. 4A. Detailed descriptions of overlapping components are provided above with reference to FIG. 4A.

Referring to FIG. 36, a bottom portion of a first vertical conductive line BLA may be isolated from a bottom portion of a second vertical conductive line BLB (refer to reference symbol "BLT").

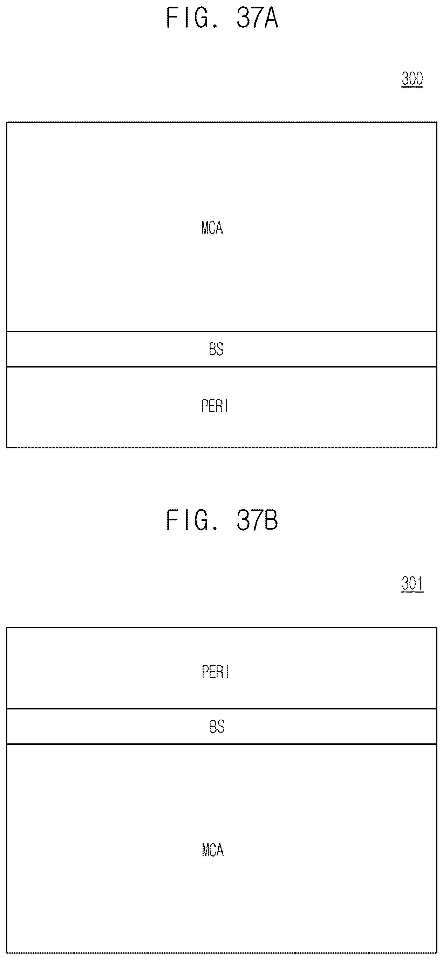

FIGS. 37A and 37B are schematic cross-sectional views of semiconductor devices 300 and 301 in accordance with embodiments of the present disclosure.

Referring to FIG. 37A, the semiconductor device 300 may include a memory cell array MCA, a peripheral circuit portion PERI, and a bonding interface BS disposed between the memory cell array MCA and the peripheral circuit portion PERI. In the semiconductor device 300, the memory cell array MCA may be disposed at a level higher than the peripheral circuit portion PERI and the semiconductor device 300 may be referred to as a "Peri Under Cell array (PUC) structure". The memory cell array MCA may include a substrate on which back-grinding is performed and an array of memory cells. For example, as described with reference to FIG. 34B, after the data storage element CAP is formed, the substrate 11 may be flipped over through wafer-flipping, and then a back side of the substrate 11 may be partially ground.

Referring to FIG. 37B, the semiconductor device 301 may include a memory cell array MCA, a peripheral circuit portion PERI, and a bonding interface BS disposed between the memory cell array MCA and the peripheral circuit portion PERI. In the semiconductor device 301, the memory cell array MCA may be disposed at a level lower than the peripheral circuit portion PERI and the semiconductor device 301 may be referred to as a "Cell array Under Peri (CUP) structure". Forming the peripheral circuit portion PERI may include forming a plurality of control circuits on a peripheral circuit substrate and forming multi-level interconnection on the control circuits.

In FIG. 37A and FIG. 37B, the bonding interface BS may include pad bonding, hybrid bonding, oxide-to-oxide bonding, metal-to-metal bonding, or a combination thereof. The hybrid bonding may refer to a combination of the pad bonding and the oxide-to-oxide bonding. The pad bonding may include forming a cell bonding pad for the memory cell array MCA, forming a peripheral circuit bonding pad for the peripheral circuit portion PERI, performing the wafer-flipping so that the cell bonding pad and the peripheral circuit bonding pad face each other, and performing wafer bonding.

The semiconductor device 300 illustrated in FIG. 37A may perform the wafer-flipping on the substrate on which the memory cell array is formed so that the cell bonding pad and the peripheral circuit bonding pad face each other, after the cell bonding pad and the peripheral circuit bonding pad are formed. The semiconductor device 301 illustrated in FIG. 37B may perform the wafer-flipping on the substrate on which the peripheral circuit portion is formed so that the cell bonding pad and the peripheral circuit bonding pad face each other, after the cell bonding pad and the peripheral circuit bonding pad are formed.

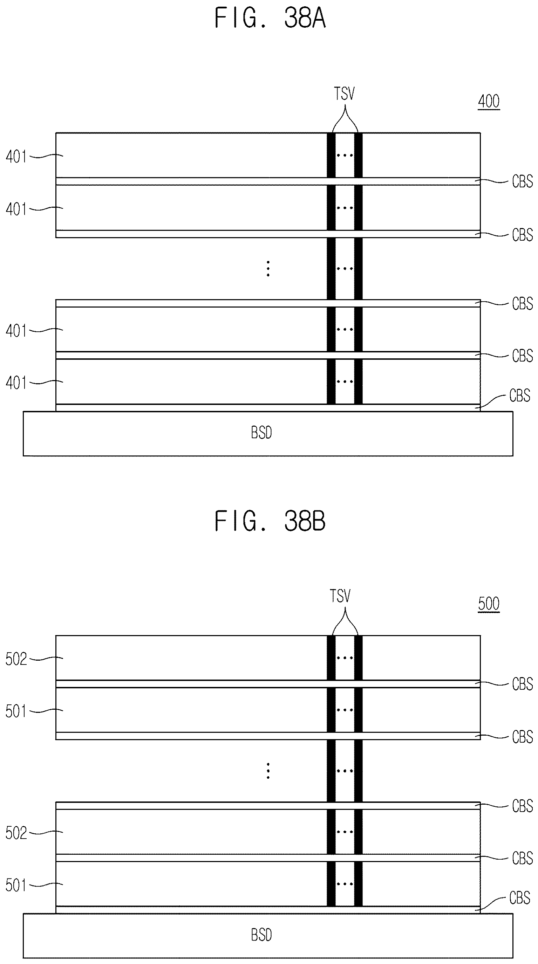

FIGS. 38A and 38B illustrate various views illustrating a stack assembly in accordance with an embodiment of the present disclosure.

Referring to FIG. 38A, a stack assembly 400 may include an assembly of semiconductor dies. For example, the stack assembly 400 may include a first semiconductor die BSD and a plurality of second semiconductor dies 401. The first semiconductor die BSD may include logic circuits. Each of the second semiconductor dies 401 may include memory cell arrays according to embodiments described above.

Each of the second semiconductor dies 401 may include structures in which a memory cell array stack and a peripheral circuit portion are stacked, for example, the semiconductor device 300 illustrated in FIG. 37A or the semiconductor device 301 illustrated in FIG. 37B. The logic circuits of the first semiconductor die BSD may be different from the peripheral circuit portions of the second semiconductor dies 401. The second semiconductor dies 401 may be at a chip level or a wafer level.

The second semiconductor dies 401 may be electrically coupled to each other through a plurality of through silicon vias TSV and bonding interfaces CBS. The first semiconductor die BSD and a lowermost second semiconductor die 401 may be electrically coupled to each other through the bonding interface CBS. The second semiconductor dies 401 may be referred to as "core dies", "semiconductor chips", or "memory chips".

The bonding interface CBS may include micro-bump, pad bonding, hybrid bonding, oxide-to-oxide bonding, metal-to-metal bonding, or a combination thereof.

Referring to FIG. 38B, a stack assembly 500 may include an assembly of semiconductor dies. For example, the stack assembly 500 may include a first semiconductor die BSD, a plurality of second semiconductor dies 501, and a plurality of third semiconductor dies 502. The first semiconductor die BSD may include logic circuits. Each of the second semiconductor dies 501 and each of the third semiconductor dies 502 may include memory cell array stacks according to embodiments described above. The second semiconductor dies 501 and the third semiconductor dies 502 may have different structures.

Each of the second semiconductor dies 501 may include the semiconductor device 300 as illustrated in FIG. 37A in which a memory cell array is stacked over a peripheral circuit portion. Each of the third semiconductor dies 502 may include the semiconductor device 301 as illustrated in FIG. 37B in which a peripheral circuit portion is stacked over a memory cell array.

In some embodiments, each of the second semiconductor dies 501 may include the semiconductor device 301 illustrated in FIG. 37B in which a peripheral circuit portion is stacked over a memory cell array, and each of the third semiconductor dies 502 may include the semiconductor device 300 illustrated in FIG. 37A in which a memory cell array is stacked over a peripheral circuit portion.

The logic circuits of the first semiconductor die BSD may be different from the peripheral circuit portions of the second and third semiconductor dies 501 and 502. The second and third semiconductor dies 501 and 502 may be at a chip level or a wafer level.

The second and third semiconductor dies 501 and 502 may be electrically coupled to each other through a plurality of through silicon vias TSV and bonding interfaces CBS. The first semiconductor die BSD and a lowermost second semiconductor die 501 may be electrically coupled to each other through the bonding interface CBS. The second and third semiconductor dies 501 and 502 may be referred to as "core dies", "semiconductor chips", or "memory chips".

The bonding interface CBS may include micro-bump, pad bonding, hybrid bonding, oxide-to-oxide bonding, metal-to-metal bonding, or a combination thereof.

According to various embodiments of the present disclosure, it is possible to reduce parasitic capacitance between horizontal conductive lines that are vertically stacked because air gaps are formed between pads that are vertically stacked.

According to various embodiments of the present disclosure, it is possible to improve the reliability of a 3D memory device.

While the present invention has been illustrated and described with respect to specific embodiments and drawings, the disclosed embodiments are not intended to be restrictive. Further, it is noted that the embodiments may be achieved in various ways through substitution, change, and modification, as those skilled in the art will recognize in light of the present disclosure, without departing from the technical concepts and/or scope of the present disclosure and the following claims. Furthermore, the embodiments may be combined to form additional embodiments.

## Claims

1. A semiconductor device comprising:
a vertical arrangement and a horizontal arrangement of nano sheets;
horizontal conductive lines horizontally oriented while surrounding the horizontal arrangement of the nano sheets;
pads coupled to edge portions of the horizontal conductive lines; and
inter-pad dielectric layers disposed between the pads, each inter-pad dielectric layer including an air gap.

2. The semiconductor device of claim 1, wherein each of the inter-pad dielectric layers includes a dielectric layer in which the air gap is embedded.

3. The semiconductor device of claim 1, wherein each of the inter-pad dielectric layers includes silicon oxide, silicon carbon oxide, or a combination thereof.

4. The semiconductor device of claim 1, wherein a horizontal length of the air gap of each of the inter-pad dielectric layers is less than a horizontal length of each of the pads.

5. The semiconductor device of claim 1, wherein each of the edge portions of the horizontal conductive lines includes a concave shape, and the pads include edges each having a convex shape.

6. The semiconductor device of claim 1, further comprising:
a vertical conductive line coupled to the vertical arrangement of the nano sheets; and
a plurality of data storage elements, each data storage element being coupled to a corresponding one of the nano sheets in the vertical and horizontal arrangements.

7. The semiconductor device of claim 6, wherein each of the nano sheets includes a flat plate-shaped sheet contacting the vertical conductive line and a fan-shaped sheet contacting the data storage element.

8. The semiconductor device of claim 7, wherein each of the nano sheets includes first and second doped regions spaced apart from each other in a second direction and a channel between the first doped region and the second doped region, and
wherein the first doped region and the channel are disposed in the flat plate-shaped sheet, and the second doped region is disposed in the fan-shaped sheet.

9. The semiconductor device of claim 6, further comprising:
first contact nodes formed between the nano sheets and the vertical conductive line; and
second contact nodes formed between the nano sheets and the data storage elements.

10. A method for fabricating a semiconductor device, the method comprising:
forming an alternating stack of pad-side sheets and pad-side sacrificial layers over a substrate;
forming growth layers on end terminals of the pad-side sheets and a strip path disposed between the growth layers;
removing the pad-side sacrificial layers through the strip path formed between the growth layers to form initial air gaps between the pad-side sheets;
forming inter-pad dielectric layers filling the initial air gaps and each including an air gap;
forming pad-shaped openings between the inter-pad dielectric layers by removing the pad-side sheets; and
forming pads filling the pad-shaped openings.

11. The method of claim 10, wherein the inter-pad dielectric layers each include silicon oxide, silicon carbon oxide, or a combination thereof.

12. The method of claim 10, wherein a horizontal length of the air gap is formed to be less than a horizontal length of each of the pads.

13. The method of claim 10, wherein a vertical height of each of the growth layers is formed to be greater than a vertical height of each of the pad-side sheets.

14. The method of claim 10, wherein the pads include edges each having a convex shape.

15. The method of claim 10, further comprising:
before forming the alternating stack,
forming nano sheet target layers stacked vertically spaced apart from each other over the substrate;
trimming first portions of the nano sheet target layers and forming flat plate-shaped sheets;
forming horizontal conductive lines horizontally oriented while surrounding the flat plate-shaped sheets; and
forming a vertical conductive line coupled to the flat plate-shaped sheets.
